(19) Europäisches Patentamt / European Patent Office / Office européen des brevets

(11) **EP 3 224 637 B1**

(12) **FASCICULE DE BREVET EUROPEEN**

(45) Date de publication et mention de la délivrance du brevet:
**31.10.2018 Bulletin 2018/44**

(21) Numéro de dépôt: **15808759.3**

(22) Date de dépôt: **26.11.2015**

(51) Int Cl.:
*G01R 31/36* (2006.01)

(86) Numéro de dépôt international:
**PCT/FR2015/053244**

(87) Numéro de publication internationale:
**WO 2016/083758 (02.06.2016 Gazette 2016/22)**

(54) **PROCEDE AUTOMATIQUE D'ESTIMATION DE LA CAPACITE D'UNE CELLULE D'UNE BATTERIE**

AUTOMATISCHES VERFAHREN ZUR SCHÄTZUNG DER KAPAZITÄT EINER ZELLE EINER BATTERIE

AUTOMATIC METHOD FOR ESTIMATING THE CAPACITY OF A CELL OF A BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.11.2014 FR 1461620**

(43) Date de publication de la demande:
**04.10.2017 Bulletin 2017/40**

(73) Titulaire: **Renault S.A.S.**
**92100 Boulogne-Billancourt (FR)**

(72) Inventeurs:
• **HEIRIES, Vincent**
**38430 Saint-Jean-de-Moirans (FR)**

• **MICHEL, Paul-Henri**
**38000 Grenoble (FR)**

(74) Mandataire: **Colombo, Michel**
**Innovation Competence Group**
**310, avenue Berthelot**
**69372 Lyon Cedex 08 (FR)**

(56) Documents cités:
**US-A1- 2006 111 854     US-A1- 2014 058 595**

• **GREGORY L. PLETT: "Extended Kalman filtering for battery management systems of LiPB-based HEV battery packs", JOURNAL OF POWER SOURCES, vol. 134, no. 2, 28 mai 2004 (2004-05-28), pages 277-292, XP055218097, ISSN: 0378-7753, DOI: 10.1016/j.jpowsour.2004.02.033**

EP 3 224 637 B1

**Description**

L'invention concerne un procédé automatique d'estimation de la capacité d'une cellule d'une batterie et un procédé d'estimation automatique de l'état de charge de cette cellule. L'invention concerne également un support d'enregistrement et un système de gestion de batterie pour mettre en oeuvre ces procédés. L'invention a également pour objet un véhicule automobile comportant ce système de gestion de batterie.

Des procédés connus d'estimation de la capacité d'une cellule d'une batterie comportent :

- a) l'acquisition, à un instant k, d'une intensité mesurée ik du courant de charge ou de décharge de la cellule,

- b) l'estimation de la capacité $C_{n,k3}$ de la cellule à un instant k3 en utilisant un filtre de Kalman, cette estimation comportant :

  - le calcul d'une prédiction de la capacité $C_{n,k3}$ à l'aide d'un modèle d'état qui relie la capacité $C_{n,k3}$ à la capacité $C_{n,k3-1}$ de cette même cellule à un instant précédent k3-1, puis
  - l'acquisition, à l'instant k3, d'une grandeur physique mesurable $z_{k3}$ définie par la relation suivante :

$$z_{k3} = \sum_{m=k-N}^{m=k-1} i_m$$

où k est l'instant le plus proche de l'instant k3 et N est un entier supérieur ou égal à un, $z_{k3}$ étant égale à $i_{k-1}$ lorsque N est égal à un,
  - le calcul d'une prédiction $\hat{z}_{k3}$ de la grandeur physique mesurable $z_{k3}$ à l'aide d'un modèle d'observation, et
  - la correction de la prédiction de la capacité $C_{n,k3}$ en fonction de l'écart entre la grandeur physique acquise $z_{k3}$ et la prédiction $\hat{z}_{k3}$ calculée à partir du modèle d'observation.

Un tel procédé est en particulier décrit dans le chapitre 4.2.2 de la partie 3 de l'article suivant : L. Plett, et al. : « Extended Kalman filtering for battery management systems of LiPB-based HEV battery packs », journal of Power Sources, 2004, page 252-292. Par la suite, cet article est désigné par l'abréviation « Plett 2004 ».

De l'état de la technique est également connu de US2006/111854A1 et US2014/058595A1.

Dans Plett 2004, le modèle d'état utilisé pour estimer la capacité est $C_{n,k3-1} = C_{n,k3} + w_{k3}$, où $w_{k3}$ est un bruit blanc gaussien centré.

Le procédé décrit dans Plett 2004 fonctionne correctement. Toutefois, il est souhaitable d'améliorer encore plus la précision de l'estimation de la capacité de la cellule de la batterie.

L'invention vise à satisfaire ce souhait en proposant un procédé automatique d'estimation de la capacité d'une cellule conforme à la revendication 1.

Le fait d'apprendre la loi $G_{SVM}$ à partir d'une base de données d'apprentissage permet d'obtenir un modèle d'état plus précis pour estimer la capacité. La capacité estimée avec ce modèle d'état appris est alors plus précise.

Les modes de réalisation de ce procédé automatique d'estimation de la capacité peuvent comporter une ou plusieurs des caractéristiques des revendications dépendantes.

Ces modes de réalisation du procédé automatique d'estimation de la capacité présentent en outre les avantages suivants :

- Imposer l'apprentissage d'une fonction sous la forme $G_{SVM}(C_{n,k3}, CC_{1,k3}) = C_{n,k3} + f_{svm}(CC_{1,k3})$ permet d'obtenir un modèle d'état linéaire. Cela augmente la précision de l'estimation de la capacité car, dans ce cas, il n'y a pas d'erreur introduite par la linéarisation du modèle d'état autour de la capacité $C_{n,k3}$.
- Déclencher l'exécution de l'algorithme d'apprentissage supervisé sur une base de données contenant les capacités précédemment estimées par le filtre de Kalman permet d'actualiser le modèle d'état et donc d'adapter automatiquement ce modèle à des changements intervenus dans la cellule.
- Déclencher une nouvelle exécution de l'algorithme d'apprentissage supervisé en réponse au dépassement d'un seuil prédéterminé par la covariance de l'erreur sur l'estimation de la capacité permet de limiter la puissance de calcul requise pour exécuter ce procédé tout en conservant une précision quasiment inchangée pour l'estimation de la capacité. En effet, dans ce cas, l'algorithme d'apprentissage supervisé est exécuté uniquement lorsque cela est nécessaire.
- Dans un mode de réalisation du procédé revendiqué, le modèle d'observation pour calculer la prédiction $\hat{z}_{k3}$ est une fonction linéaire de la capacité $C_{n,k3}$. Par conséquent, le calcul de la prédiction $\hat{z}_{k3}$ n'est pas entaché d'erreurs liées à la linéarisation du modèle d'observation autour de la valeur $C_{n,k3}$. A l'inverse, le modèle d'observation décrit au chapitre 4.2.2 de Plett 2004 est non linéaire et doit donc nécessairement être linéarisé autour de la capacité $C_{n,k3}$. Une telle linéarisation se traduit nécessairement par des erreurs d'estimation sur la capacité corrigée $C_{n,k3}$. De plus, cette opération de linéarisation du modèle d'observation consomme de la puissance de calcul.

Un mode de réalisation de l'invention a également pour objet un procédé automatique d'estimation de l'état de charge d'une cellule d'une batterie conforme à la revendication 8.

Les modes de réalisation de ce procédé automatique d'estimation de l'état de charge peuvent comporter une ou plusieurs des caractéristiques des revendications dépendantes.

Ces modes de réalisation du procédé automatique d'estimation de l'état de charge présentent en outre les avantages suivants :

- L'estimation des coefficients d'un filtre à réponse impulsionnelle infinie et l'utilisation de ce filtre dans le modèle d'état utilisé pour estimer la capacité permet d'améliorer la précision de l'estimation de l'état de charge de la cellule.

L'invention, selon la revendication 11, a également pour objet un support d'enregistrement d'informations comportant des instructions pour l'exécution de l'un quelconque des procédés automatiques d'estimation ci-dessus lorsque ces instructions sont exécutées par un calculateur électronique.

L'invention, selon la revendication 12, a également pour objet un système de gestion d'une batterie équipé d'au moins une cellule, ce système comportant un calculateur électronique programmé pour mettre en oeuvre le procédé revendiqué.

Enfin, un mode de réalisation de l'invention a également pour objet un véhicule automobile comportant le système revendiqué de gestion de la batterie.

L'invention sera mieux comprise à la lecture de la description qui va suivre, donnée uniquement à titre d'exemple non limitatif et faite en se référant aux dessins sur lesquels :

- la figure 1 est une illustration schématique partielle d'un véhicule automobile équipé d'une batterie électrique,
- la figure 2 est une illustration schématique d'un modèle électrique d'une cellule de la batterie du véhicule de la figure 1 ;
- la figure 3 est une illustration schématique d'un agencement d'estimateurs utilisé pour estimer l'état de charge d'une cellule de la batterie du véhicule de la figure 1,
- les figures 4 à 7 représentent des équations de différents modèles d'état et d'observation utilisés par les estimateurs de la figure 3 ;
- la figure 8 est un organigramme d'un procédé d'estimation de l'état de charge d'une cellule à l'aide des estimateurs de la figure 3 ;
- les figures 9 et 10 représentent d'autres, respectivement, un modèle d'état et un modèle d'observation utilisés dans le procédé de la figure 8.

Dans ces figures, les mêmes références sont utilisées pour désigner les mêmes éléments. Dans la suite de cette description, les caractéristiques et fonctions bien connues de l'homme du métier ne sont pas décrites en détail.

Dans cette description par « puissance de calcul », on désigne le nombre d'opérations à exécuter par un calculateur électronique. Ainsi, diminuer la puissance de calcul signifie diminuer le nombre d'opérations à réaliser pour atteindre le même résultat ou un résultat de même nature.

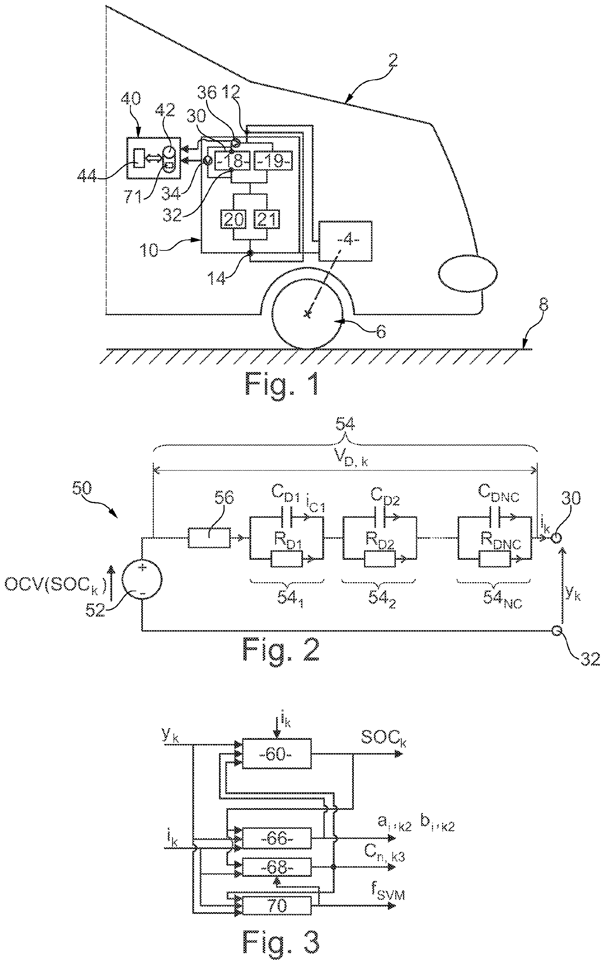

La figure 1 représente un véhicule automobile 2 à traction électrique plus connu sous le terme de « véhicule électrique ». Les véhicules électriques sont bien connus et seuls les éléments structurels nécessaires pour comprendre la suite de cette description sont présentés. Le véhicule 2 comporte :

- un moteur électrique 4, apte à entraîner en rotation des roues motrices 6 pour faire rouler le véhicule 2 sur une chaussée 8, et
- une batterie 10 qui alimente en énergie électrique le moteur 4.

La batterie 10 comporte deux bornes 12, 14 de raccordement électrique et plusieurs cellules électriques raccordées électriquement entre ces bornes 12 et 14. Les bornes 12 et 14 sont raccordées aux charges électriques à alimenter. Ici, elles sont donc notamment raccordées au moteur électrique 4.

Pour simplifier la figure 1, seules quatre cellules électriques 18 à 21 sont représentées. Typiquement, ces cellules électriques sont regroupées en plusieurs étages et ces étages sont raccordés en série entre les bornes 12 et 14. Ici, seuls deux étages sont représentés. Le premier étage comporte les cellules 18 et 19, et le second étage comporte les cellules 20 et 21. Chaque étage comporte plusieurs branches raccordées en parallèle. Chaque branche d'un étage comporte une cellule électrique ou plusieurs cellules électriques en série. Ici, le premier étage comporte deux branches, et chaque branche comporte une seule cellule électrique. Le deuxième étage est structurellement identique au premier étage dans l'exemple représenté sur la figure 1.

Ici, toutes les cellules de la batterie 10 sont structurellement identiques aux tolérances de fabrication près. Par conséquent, seule la cellule 18 est maintenant décrite plus en détail.

La cellule 18 comporte deux bornes de raccordement électrique 30, 32 qui la raccordent électriquement aux autres cellules et aux bornes 12 et 14 de la batterie 10. La cellule 18 est aussi fixée mécaniquement, sans aucun degré de liberté aux autres cellules de la batterie 10 pour former ce que l'on appelle fréquemment un « pack » de cellules. La cellule 18 est capable de stocker de l'énergie électrique lorsqu'elle n'est pas utilisée. Cette énergie électrique stockée est ensuite utilisée pour alimenter le moteur 4, ce qui décharge la cellule 18. En alternance, la cellule 18 peut aussi recevoir de l'énergie électrique ce qui la charge. La décharge complète d'une cellule suivie de sa recharge complète constitue ce que l'on appelle un cycle de charge/décharge appelé simplement par la suite « cycle d'une cellule ».

La cellule 18 est une cellule de type connu, par exemple, il s'agit d'une cellule LiPB (Lithium-ion Polymer Battery) ou autre.

La cellule 18 se caractérise par une capacité nominale initiale $C_n^{ini}$, une résistance interne initiale $RO^{ini}$, une intensité $I_{max}$ de courant débité, une tension maximale $U_{max}$, une tension minimale $U_{min}$ et une fonction $OCV(SOCk)$. La capacité $C_n^{ini}$ est la capacité initiale de la cellule 18. La capacité d'une cellule représente la quantité maximale d'énergie électrique qui peut être stockée dans cette cellule. Cette capacité est exprimée en Ah. Au fur et à mesure que la cellule 18 vieillit, c'est-à-dire au fur et à mesure que le nombre de cycles de charge et de décharge augmente, la capacité de la cellule diminue. À l'instant k, la capacité nominale de la cellule 18 est notée $C_{n,k}$ par la suite.

La résistance interne initiale $RO^{ini}$ est la valeur de la résistance interne de la cellule 18 avant que celle-ci ne commence à vieillir. La résistance interne d'une cellule est une grandeur physique que l'on retrouve dans la plupart des modèles électriques d'une cellule électrique. Lorsque la cellule vieillit, typiquement, la résistance interne augmente. À l'instant k, la résistance interne de la cellule 18 est notée $RO_k$.

$I_{max}$ est l'intensité maximale du courant qui peut être délivrée par la cellule 18 sans l'endommager.

$U_{max}$ est la tension maximale qui peut être présente en permanence entre les bornes 30 et 32 de la cellule sans l'endommager.

La tension $U_{min}$ est la tension minimale entre les bornes 30 et 32 lorsque la cellule 18 est complètement déchargée.

$OCV(SOC_k)$ est une fonction prédéterminée qui retourne la tension à vide de la cellule 18 en fonction de son état de charge SOCk. La tension à vide est la tension mesurable entre les bornes 30 et 32 après que la cellule 18 ait été isolée électriquement de toute charge électrique pendant deux heures.

L'état de charge à l'instant k de la cellule 18 est noté SOCk. L'état de charge représente le taux de remplissage de la cellule 18. Il est égal à 100 % lorsque la quantité d'énergie électrique stockée dans la cellule 18 est égale à sa capacité $C_{n,k}$. Il est égal à 0 % lorsque la quantité d'énergie stockée dans la cellule 18 est nulle, c'est-à-dire qu'il ne peut plus être extrait d'énergie électrique de la cellule 18 pour alimenter une charge électrique.

Les paramètres $C_n^{ini}$, $RO^{ini}$, $I_{max}$, $U_{max}$, $U_{min}$ et la fonction $OCV(SOC_k)$ sont des paramètres connus de la cellule. Par exemple, ils sont donnés par le constructeur de la cellule ou sont déterminés expérimentalement à partir de mesures réalisées sur cette cellule.

La batterie 10 comporte également pour chaque cellule :

- un voltmètre qui mesure la tension entre les bornes de cette cellule, et
- un ampèremètre qui mesure l'intensité du courant de charge et de décharge de cette cellule.

Pour simplifier la figure 1, seuls un voltmètre 34 et un ampèremètre 36 de la cellule 18 ont été représentés.

Contrairement aux différents paramètres de la cellule 18 introduits précédemment, l'état de charge $SOC_k$ de la cellule 18 n'est pas mesurable. Il doit donc être estimé. À cet effet, le véhicule 2 comporte un système 40 de gestion de la batterie 10 plus connu sous l'acronyme BMS (« Battery Management System »). Ce système 40 a notamment pour fonction de déterminer l'état de charge de la batterie 10 ainsi que l'état de santé de cette batterie. Pour déterminer cet état de charge et cet état de santé, le système 40 est capable d'estimer l'état de charge et l'état de santé de chaque cellule de la batterie 10. L'état de santé d'une cellule représente l'état d'avancement du vieillissement de cette cellule. Ici, l'état de santé d'une cellule, à l'instant k, est noté $SOH_k$. Par la suite, il est mesuré par le rapport $C_{n,k}/C_n^{ini}$. Pour calculer l'état de santé d'une cellule, le système 40 est donc aussi capable d'estimer la capacité $C_{n,k}$ de cette cellule à l'instant courant k.

Pour réaliser ces différentes estimations, le système 40 est électriquement raccordé à chaque voltmètre et chaque ampèremètre de la batterie 10 pour acquérir les mesures de la tension et de l'intensité du courant entre les bornes de chaque cellule.

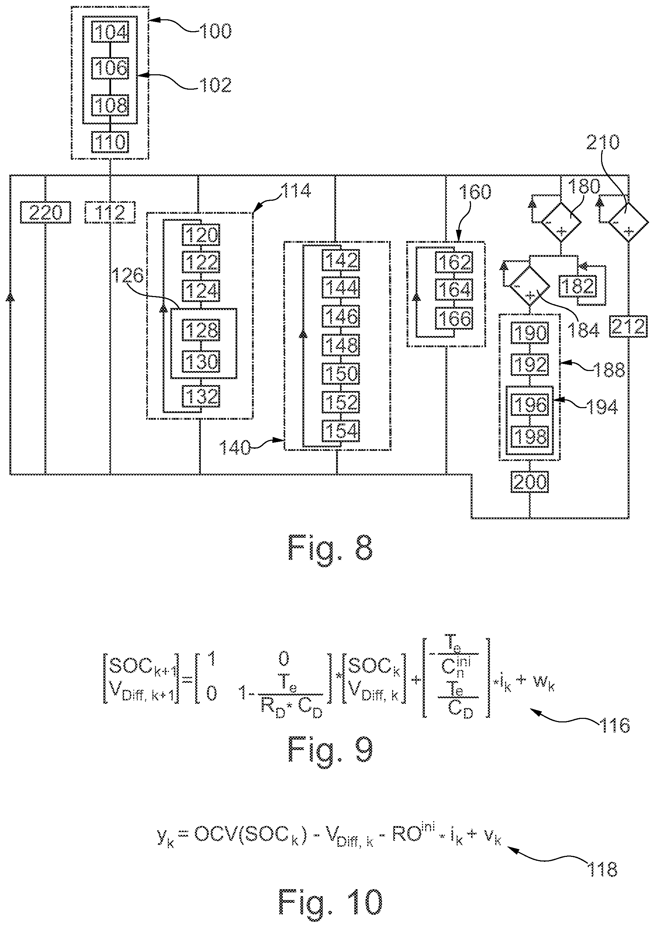

Ici, le système 40 comporte une mémoire 42 et un calculateur électronique 44 programmable apte à exécuter des instructions enregistrées dans la mémoire 42. À cet effet, la mémoire 42 comporte les instructions nécessaires pour l'exécution du procédé de la figure 8. Cette mémoire 42 comporte aussi les valeurs initiales des différents paramètres nécessaires à l'exécution de ce procédé. La structure du système 40 est donc identiques ou similaire à celles des systèmes connus de gestion d'une batterie et n'est pas décrite plus en détail.

La figure 2 représente un modèle électrique 50 de la cellule 18. Ce modèle comporte successivement raccordés en série en partant de la borne 32 jusqu'à la borne 30 :

- un générateur 52 de la tension à vide OCV($SOC_k$), et
- une impédance 54.

L'impédance 54 comporte une résistance 56 et $N_c$ circuits RC parallèles $54_L$ raccordés en série, où l'indice L est un indice, compris entre 1 et $N_c$, qui identifie le circuit RC des autres circuits RC du modèle 50. La résistance 56 correspond à la résistance interne de la cellule 18. Chaque circuit $54_L$ comporte un condensateur de capacité $C_{DL}$ raccordé en parallèle avec une résistance de valeur $R_{DL}$. La résistance 56 et les deux paramètres $C_{DL}$ et $R_{DL}$ de chaque circuit RC sont inconnus et sont donc à déterminer. La tension à l'instant k aux bornes de l'impédance 54 est notée $V_{D,k}$ par la suite. La valeur à l'instant k de la tension entre les bornes 30 et 32 de la cellule 18 est notée $y_k$ et l'intensité, au même instant, du courant de charge ou de décharge de la cellule 18 est notée $i_k$.

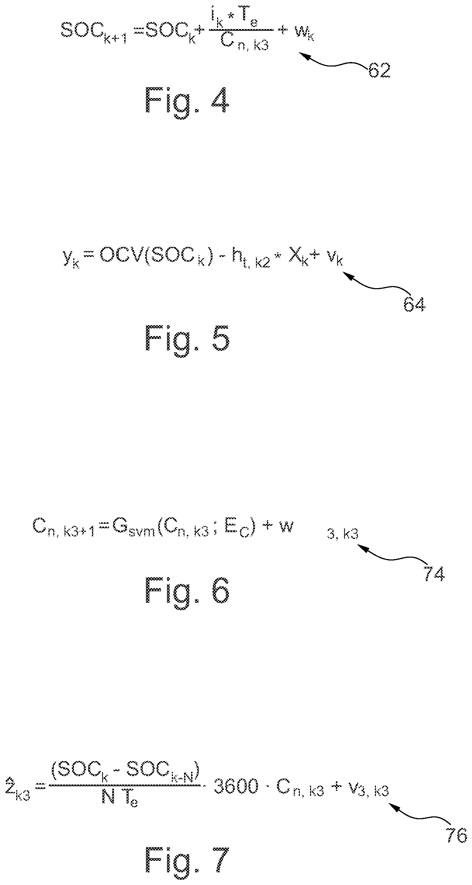

La figure 3 représente un premier mode de réalisation d'un agencement d'estimateurs implémenté dans le système 40 pour estimer la capacité de la cellule 18 et son état de charge. Chaque estimateur est implémenté sous la forme d'un algorithme d'estimation exécuté par le calculateur 44. Ainsi, on parlera pas la suite aussi bien « d'exécution d'un estimateur » que « d'exécution d'un algorithme d'estimation ». Dans ce premier mode de réalisation, le système 40 comporte un estimateur 60 de l'état de charge $SOC_k$ à partir de la valeur mesurée $y_k$ de la tension et de l'intensité mesurée $i_k$. L'estimateur 60 est ici implémenté sous la forme d'un filtre de Kalman. Il utilise donc un modèle d'état 62 (figure 4) et un modèle d'observation 64 (figure 5). Dans ces figures 4 et 5, les équations de ces modèles sont représentées en utilisant les notations précédemment définies. Les notations $h_{t,k2}$ et $C_{n,k3}$ représentent, respectivement, un filtre et la capacité de la cellule 18, respectivement, à des instants k2 et k3. Typiquement, les instants k2 et k3 appartiennent chacun à un sous-ensemble de l'ensemble des instants k. Dans les modèles 62 et 64, les instants k2 et k3 sont les instants de ces sous-ensembles les plus proches de l'instant k. Dans le modèle 62, SOCk est la variable d'état.

Par la suite, on considère que l'origine des temps correspond à la valeur nulle de l'instant k. Dans ces conditions, l'instant k courant est égal à $kT_e$, où $T_e$ est la période d'échantillonnage des mesures des ampèremètres et voltmètres de la batterie 10. Ainsi, $T_e$ est la période de temps qui sépare deux instants quelconques successifs k et k-1 d'acquisition de la tension et de l'intensité du courant par le système 40. La période $T_e$ est typiquement une constante comprise entre 0,1s et 10s. Ici, la période $T_e$ est égale à 1s à plus ou moins 20 % près. Par exemple, $T_e$ est égale à une seconde.

Dans le modèle 62, wk est un bruit d'état. Ici, le bruit wk est un bruit blanc gaussien centré. Ce bruit représente l'incertitude sur le modèle utilisé. La matrice de covariance, à l'instant k, du bruit wk est notée $Q_k$. Elle est définie par la relation suivante: $Q_k = E(w_k*w_k^T)$, où E(...) est la fonction espérance mathématique. Le modèle 62 s'écrit également sous la forme $X_{k+1} = F_k x_k + B_k i_k + w_k$, où :

- $F_k$ est la matrice de transition d'état à l'instant k,
- $B_k$ est le vecteur de commande à l'instant k.

Le modèle 62 permet notamment de prédire l'état de charge $SOC_{k+1}$ à l'instant k+1 à partir de l'état de charge précédant SOCk.

Le modèle 64 permet de prédire la valeur $y_k$ de la tension à l'instant k à partir de l'état de charge SOCk et d'un vecteur Xk. Dans le modèle 64, $X_k$ est le vecteur suivant $[i_k, i_{k-1}, ..., i_{k-Nh}, V_{D,k-1}, V_{D,k-2} ..., V_{D,k-Mh}]^T$. Dans cette description, le symbole « $^T$ » désigne l'opération transposée mathématique. L'opération multiplication est représentée par l'opérateur « . » ou « * ». Nh et Mh sont des entiers positifs prédéterminés. Ici, Nh et Mh sont chacun supérieurs ou égale à deux. De préférence, Nh et Mh appartiennent à l'ensemble [3 ; 10]. Ici, Nh et Mh sont tous les deux égaux à quatre.

Le produit $h_{t,k2}*X_k$ retourne une prédiction $Vp_{D,k}$ de la tension $V_{D,k}$ aux bornes de l'impédance 54. Dans ce mode de réalisation, l'impédance 54 est modélisée par un filtre $h_{t,k2}$ à réponse impulsionnelle infinie. Le filtre $h_{t,k2}$ est défini par la relation suivante :

$$Vp_{D,k} = h_{t,k2} * X_k = \sum_{i=0}^{i=Nh} b_{i,k2} * i_{k-i} - \sum_{i=1}^{i=Mh} a_{i,k2} * V_{D,k-i}$$

où $b_{i,k2}$ et $a_{i,k2}$ sont les coefficients du filtre $h_{t,k2}$ mis à jour à l'instant k2 le plus proche de l'instant k.

Dans le modèle 64, $v_k$ est un bruit de mesure blanc gaussien centré. La matrice de covariance du bruit $v_k$ à l'instant k est notée $R_k$ par la suite. Dans le cas particulier décrit ici, cette matrice $R_k$ est une matrice à une seule colonne et à une seule ligne. Elle est définie par la relation $R_k = E(v_k \cdot v_k^T)$. Ce bruit vk est indépendant du bruit $w_k$ et de l'état de charge initial $SOC_0$.

On notera que le modèle 64 est non linéaire, car la fonction $OCV(SOC_k)$ est généralement non linéaire. À cause de cela, l'estimateur 60 implémente la version du filtre de Kalman à points Sigma, plus connu sous l'acronyme SPK (Sigma Point Kalman Filter). L'implémentation d'un filtre de Kalman à points Sigma est décrite en détail dans les articles suivants :

- Julier J. Simon et Al: « A New Extension of the Kalman Filter to Nonlinear Systems », Proc. SPIE 3068, Signal Processing, Sensor Fusion, and Target Récognition VI, 182 (28/07/1997), et
- Gregory L. Plett : « Sigma-point Kalman filtering for battery management systems of LiPB-based HEV battery packs », Journal of Power Sources 161 (2006) 1356-1368.

Les articles ci-dessus ne décrivent pas l'implémentation d'un filtre de Kalman à points Sigma utilisant exactement les mêmes modèles d'état et d'observation que les modèles 62, 64. Toutefois, à partir des informations données ici et de l'enseignement de ces articles, l'homme du métier est capable de programmer, sans difficulté excessive, un filtre de Kalman à points Sigma qui utilise les modèles 62 et 64.

L'estimateur 60 a besoin de connaître la capacité $C_{n,k3}$ et les coefficients du filtre $h_{t,k2}$ pour être capable d'estimer l'état de charge $SOC_{k+1}$. La capacité et les coefficients du filtre $h_{t,k2}$ de la cellule 18 varient au fur et à mesure que la cellule 18 vieillit. Pour tenir compte de ce vieillissement, la capacité et les coefficients du filtre $h_{t,k2}$ de la cellule 18 sont estimés, respectivement, à des instants k3 et k2. Ici, un estimateur 66 estime les coefficients du filtre $h_{t,k2}$ à partir notamment de la valeur mesurée $y_{k2}$, de l'intensité mesurée $i_{k2}$ et de l'état de charge $SOC_{k2}$. Un autre estimateur 68 estime la capacité $C_{n,k3}$ à partir de l'intensité $i_{k3}$ et de l'état de charge $SOC_{k3}$.

Les coefficients du filtre $h_{t,k2}$ et la capacité de la cellule 18 varient plus lentement que son état de charge. Ainsi, pour limiter la puissance de calcul requise pour estimer l'état de charge de la cellule sans pour autant dégrader la précision de cette estimation, les estimateurs 66 et 68 sont exécutés moins fréquemment que l'estimateur 60. Ici, les instants d'exécution des estimateurs 66 et 68 sont notés, respectivement, k2 et k3 pour les distinguer des instants k. L'ensemble des instants k2 et l'ensemble des instants k3 sont des sous-ensembles de l'ensemble des instants k. Par conséquent, entre deux instants successifs k2 et k2-1 et entre deux instants successifs k3 et k3-1, il s'écoule plusieurs périodes $T_e$ et plusieurs instants k.

L'estimateur 66 implémente un algorithme des moindres carrés récursifs plus connu sous l'acronyme RLS (Recursive Least Square). L'algorithme RLS est bien connu et seul son principe de fonctionnement est rappelé dans le procédé de la figure 8.

L'estimateur 68 est implémenté sous la forme d'un filtre de Kalman. Il utilise un modèle d'état 74 (figure 6) et un modèle d'observation 76 (figure 7). Dans les modèles 74 et 76, les bruits $w_{3,k3}$ et $v_{3,k3}$ sont des bruits blancs gaussiens centrés. Les covariances des bruits $w_{3,k3}$ et $v_{3,k3}$ sont notées respectivement $Q_{3,k3}$ et $R_{3,k3}$ par la suite.

Dans le modèle 74, la fonction $G_{SVM}$ est une fonction qui retourne la capacité $C_{n,k3}$ à partir de la capacité $C_{n,k3-1}$ et d'un ensemble Ec de caractéristiques physiques $cc_{j,k3}$ mesurées ou estimées à l'instant k3 sur la cellule 18 ou sur le véhicule 2. Les caractéristiques de l'ensemble Ec ont en commun d'avoir une influence sur l'évolution de la capacité de la cellule au cours du temps. Elles sont donc corrélées à l'évolution temporelle de la capacité de la cellule 18. L'ensemble Ec comprend au moins une caractéristique physique $cc_{1,k3}$ et, de préférence, une ou plusieurs caractéristiques physiques supplémentaires $cc_{j+1,k3}$, où l'indice j est un entier constant supérieur ou égale à un et, par exemple, inférieur à cinq ou trois. Typiquement, au moins l'une des caractéristiques de l'ensemble Ec est choisie dans le groupe composé de l'intensité $i_{k3}$ et de la valeur $y_{k3}$. De préférence, la caractéristique $cc_{1,k3}$ est l'intensité $i_{k3}$. En effet, l'intensité du courant de charge ou de décharge de la cellule 18 est connue comme étant une caractéristique qui est corrélée à l'évolution de la capacité au cours du temps. Il est également préférable que la seconde caractéristique $cc_{2,k3}$ soit la valeur mesurée $y_{k3}$. En effet, comme pour l'intensité du courant, il est connu que la tension entre les bornes 30, 32 est une caractéristique qui est corrélée à l'évolution de la capacité de la cellule. Ensuite, l'une des caractéristiques supplémentaires est la température $T_{k3}$ de la cellule 18 mesurée à l'instant k3 si celle-ci est disponible ou la profondeur de décharge $DoD_{k3}$ de la cellule 18. La profondeur $DoD_{k3}$ est connue sous l'acronyme DoD (Depth of Discharge). Ici, elle est obtenue à l'aide de la relation suivante : $DoD_{k3} = 1-SOC_{k3}$. Enfin, tout autre caractéristique qui est corrélée à l'évolution de la capacité de la cellule peut être incorporée à l'ensemble Ec. Un exemple d'une telle autre caractéristique est l'accélération du véhicule 2 ou sa vitesse. Dans, ce mode réalisation, l'ensemble Ec comporte seulement deux caractéristiques $cc_{1,k3}$ et $cc_{2,k3}$ égales, respectivement, à l'intensité $i_{k3}$ et la valeur mesurée $y_{k3}$.

De préférence, la fonction $G_{SVM}$ est définie par la relation suivante : $G_{SVM}(C_{n,k3-1}; Ec) = C_{n,k3-1} + f_{svm}(Ec)$, où $f_{svm}(Ec)$ est une fonction apprise qui retourne l'écart entre les capacités $C_{n,k3}$ et $C_{n,k3-1}$ en fonction des caractéristiques physiques de l'ensemble Ec. Écrit sous cette forme, le modèle 74 est une fonction linéaire de la capacité $C_{n,k3}$. Le modèle 76 est aussi un modèle linéaire. Il n'est donc pas nécessaire d'avoir recours à une implémentation du filtre de Kalman qui linéarise ces modèles autour de la capacité $C_{n,k3}$. Ainsi, la précision de l'estimation de la capacité de la cellule 18 est accrue avec ces modèles 74, 76 car on évite les erreurs d'approximation qu'introduit inévitablement une linéarisation de ces modèles. Ici, un simple filtre de Kalman est utilisé pour implémenter l'estimateur 68 au lieu d'un filtre de Kalman étendu.

Le modèle 76 d'observation permet d'estimer une grandeur physique $z_{k3}$ directement mesurable. La grandeur physique $z_{k3}$ est ici la somme de N dernières intensités mesurées $i_k$. Elle est définie par la relation suivante :

$$z_{k3} = \sum_{m=k-N}^{m=k-1} i_m$$

Dans la relation ci-dessus et dans le modèle 76, l'instant k est égal à l'instant k3. Cette grandeur physique $z_{k3}$ tient compte non seulement de l'intensité mesurée $i_{k-1}$ à l'instant k-1 précédent l'instant k3 mais également de N précédentes intensités mesurées entre les instants k3 et k3-1. Ici, N est un entier strictement supérieur à un qui est compté comme cela sera décrit plus loin. Le fait de prendre en compte des mesures intermédiaires entre les instants k3 et k3-1, permet d'augmenter la précision de l'estimation de la capacité $C_{n,k3}$.

Dans ce mode de réalisation, la fonction $f_{SVM}$ du modèle 74 est initialement apprise à partir d'une base de données expérimentale puis réapprise au cours de l'utilisation du système 40 dans le véhicule 2. A cet effet, le système 40 implémente donc également une machine 70 d'apprentissage supervisé et contient une base de données 71 (figure 1) qui contient les données nécessaires à l'apprentissage. La machine 70 fonctionne, en alternance ou en même temps, dans deux modes différents, appelés ici, respectivement, « mode d'apprentissage » et « mode d'utilisation ». Dans le mode d'apprentissage, la machine 70 construit une base de données contenant pour un très grand nombre d'instants k3, la capacité $C_{n,k3}$ et les caractéristiques de l'ensemble Ec mesurées ou estimées au même instant. Dans ce mode de réalisation, à cet effet, elle reçoit l'intensité $i_{k3}$, la valeur mesurée $y_{k3}$ et la capacité $C_{n,k3}$ estimée par l'estimateur 68. Le nombre d'instants k3 pris en compte pour construire la base de données est par exemple supérieur à 50 ou 100. Toujours dans le mode d'apprentissage, une fois que la base de données 71 contient suffisamment de données, la machine 70 exécute un algorithme d'apprentissage supervisé pour apprendre la fonction $f_{SVM}(Ec)$. Cet apprentissage est exécuté à des instants k4 qui sont, typiquement, moins fréquents que les instants k3. Par exemple, le nombre d'instants k4 est au moins 5 ou 10 ou 100 fois inférieur au nombre d'instants k3. Ici, l'algorithme d'apprentissage supervisé est une machine à vecteurs supports plus connue sous l'acronyme SVM (« support vector machine »). Les machines à vecteur support sont bien connues. La machine 70 n'est donc pas décrite ici en détail. On rappelle simplement qu'une telle machine construit automatiquement des hyperplans qui permettent de séparer les caractéristiques physiques de l'ensemble Ec en différentes classes, chaque classe étant associée à une valeur particulière de l'écart entre les capacités $C_{n,k3}$ et $C_{n,k3-1}$. Pour arriver à classer les caractéristiques physiques de l'ensemble Ec en différentes classes, la machine 70 est notamment capable d'effectuer des changements de système d'axes non linéaires. De tels changements de système d'axes non colinéaires sont connus sous le terme anglais de « kernel trick ».

Classiquement, avant de lancer l'apprentissage de la fonction $f_{SVM}$, des paramètres C, $\varepsilon$ et $\gamma$ de la machine 70 doivent être réglés. Le paramètre C est le paramètre de pénalité sur le terme d'erreur. C'est un paramètre qui permet de jouer sur la complexité de l'hyperplan à trouver, sachant que l'on pénalise plus ou moins fort les fausses classification. Le paramètre $\varepsilon$ est le paramètre qui joue sur la largeur de la marge autorisée. Il caractérise assez bien la précision que l'on aura sur la régression. Le paramètre $\gamma$ représente le paramètre du noyau gaussien permettant une marge de manoeuvre plus ou moins grande dans le cadre du kernel trick. Ici, ces paramètres sont réglés en appliquant la méthode décrite dans l'article suivant : V. Cherkassky : Yunqian Ma Vladimir Cherkassky : « Practical selection of svm parameters and noise estimation for svm régression », ELSEVIER, Neural Networks, 2003.

La machine 70 est, par exemple, réalisée à partir de la boîte à outils libsvm qui peut être téléchargée à partir de plusieurs sites Internet comme le site http://www.csie.ntu.edu.tw/~cjlin/libsvm/. Cette boîte à outils a l'avantage de s'interfacer facilement avec un grand nombre de logiciels comme par exemple Matlab®.

Une fois que la conjonction $f_{SVM}$ a été apprise, la machine 70 peut fonctionner dans le mode d'utilisation. Dans le mode d'utilisation, à chaque instant k3, la machine 70 reçoit les valeurs des caractéristiques de l'ensemble Ec et renvoie, en réponse, à l'estimateur 68, la valeur de la fonction $f_{SVM}(Ec)$ à l'instant k3.

Le fonctionnement du système 40 va maintenant être décrit à l'aide du procédé de la figure 8 et dans le cas particulier de l'estimation de l'état de charge de la cellule 18.

Le procédé débute par une phase 100 d'initialisation du système 40. Lors d'une étape 102, la machine 70 réalise un apprentissage initial de la fonction $f_{SVM}$. Pour cela, lors d'une opération 104, l'intensité $i_k$, la valeur mesurée $y_k$ et la capacité de la cellule 18 sont enregistrées dans une base de données pour un grand nombre d'instants différents. Typiquement, l'opération 104 est réalisée en laboratoire et sur une cellule identique à la cellule 18 mais qui n'est pas nécessairement la cellule 18 elle-même. En laboratoire, il est possible de mesurer la capacité $C_{n,k}$ à chaque instant k. Par exemple, la capacité $C_{n,k}$ est mesurée par spectroscopie d'impédance ou par spectroscopie d'impédance électrochimique.

Lors d'une opération 106, la base de données ainsi construite est acquise par la machine 70. Par exemple, elle est enregistrée dans la mémoire 42 en tant que base 71 de données d'apprentissage.

Enfin, lors d'une opération 108, la machine 70 exécute l'algorithme d'apprentissage supervisé pour apprendre la fonction $f_{SVM}$ initiale en utilisant les données enregistrées dans la base 71.

L'étape 102 s'achève lorsque l'apprentissage de la fonction $f_{SVM}$ est achevé. Cette fonction $f_{SVM}$ apprise initialement est alors enregistrée dans la mémoire 42.

Lors d'une étape 110, les matrices de covariance $Q_0$ et $R_0$ de l'estimateur 60 sont réglées. Ici, ces matrices $Q_0$ et $R_0$ sont réglées en mettant en oeuvre une méthode conventionnelle. Par exemple, la matrice $R_0$ est réglée à partir des données fournies par le constructeur des capteurs ou à partir de tests réalisés sur ces capteurs. La matrice $Q_0$ est réglée par essais successifs. A titre d'illustration, la matrice $Q_0$ est prise égale à $10^{-3}$.

Lors de l'étape 110, les covariances $Q_{3,0}$ et $R_{3,0}$ de l'estimateur 68 sont réglées. Par exemple, la covariance $Q_{3,0}$ est prise égale à $[y_c*C_n^{ini}/(3*N^c_{eol}*N_S)]^2$, où $y_c$ représente, exprimée en pourcentage divisé par 100, l'écart entre la capacité $C_n^{ini}$ et la capacité de la cellule 18 en fin de vie. $y_c$ est une constante choisie par l'utilisateur entre 0,05 et 0,8 et, de préférence, entre 0,05 et 0,3. Ici, y = 0,2.

La covariance $R_{3,0}$ est par exemple choisie égale à $[2*\varepsilon_{im}*I_{max}/300]^2$, où $\varepsilon_{im}$ est l'erreur maximale de l'ampèremètre 36 exprimée en pourcentage.

Par la suite, pour simplifier la description, les covariances $Q_{3,k3}$ et $R_{3,k3}$ sont considérées comme étant constantes et prises égales, respectivement, à $Q_{3,0}$ et $R_{3,0}$. Toutefois, en variante, il est aussi possible de les mettre à jour à chaque instant k3, par exemple, en fonction de l'innovation, et en appliquant des méthodes connues.

Une fois la phase 100 d'initialisation terminée, l'estimation de l'état de charge de la cellule 18 peut commencer.

Lors d'une phase 112, à chaque instant k, le voltmètre 34 et l'ampèremètre 36 mesurent, respectivement, la valeur $y_K$ et l'intensité $i_k$ et ces mesures sont immédiatement acquises par le système 40 et enregistrées dans la mémoire 42. La phase 112 est réitérée à chaque instant k.

Dans ce mode de réalisation, si les coefficients du filtre $h_{t,k2}$ sont inconnus, l'estimateur 60 ne peut pas être exécuté. Dans ce cas, en parallèle de la phase 112, le calculateur 44 commence par exécuter une phase 114 d'estimation de l'état de charge $SOC_k$ de la cellule 18 à l'aide d'un autre algorithme d'estimation qui n'utilise pas le filtre $h_{t,k2}$. Ici, cette autre algorithme est un filtre de Kalman étendu utilisant un modèle d'état 116 (figure 9) et un modèle d'observation 118 (figure 10). Le modèle 116 est obtenu à partir d'un modèle électrique simplifié de la cellule 18 dans lequel l'impédance 54 ne comporte qu'un seul circuit RC parallèle. La résistance $R_D$ et la capacité $C_D$ de ce circuit RC parallèle sont de plus considérées comme des constantes prédéterminées. La tension $V_{Diff,k}$ est la tension à l'instant k aux bornes de ce circuit RC. Cette tension $V_{Diff,k}$ n'est pas directement mesurable. Ainsi, dans le modèle 116, elle est traitée comme une variable d'état supplémentaire à estimer. Dans le modèle 116, on considère que la capacité de la cellule 18 est constante et égale à sa valeur initiale $C_n^{ini}$. Cette hypothèse est raisonnable et n'introduit que très peu d'erreur car la phase 114 est exécutée juste après le début de l'utilisation du système 40. A ce stade là, la cellule 18 n'a pas eu le temps de vieillir.

Le modèle 118 est identique au modèle 64 sauf que le produit $h_{t,k2}*X_k$ est remplacé par la somme $V_{Diff,k} + RO^{ini}*i_k$. $RO^{ini}$ est la valeur initiale de la résistance interne de la cellule 18. Dans ce modèle 118, la valeur $RO^{ini}$ est une constante. Cette hypothèse introduit elle aussi que très peu d'erreur car la phase 114 est exécutée à un stade où la cellule 18 n'a pas encore eu le temps de vieillir.

Les modèles 116 et 118 sont indépendants des coefficients du filtre $h_{t,k2}$. Il est donc possible de commencer à estimer l'état de charge $SOC_k$ avec ces modèles sans attendre que les coefficients du filtre $h_{t,k2}$ soient déterminés.

Lors de la phase 114 les matrices de covariance des bruits blancs gaussiens centrés $w_k$ et $v_k$ des modèles 116 et 118 sont réglées de façon similaire à ce qui a été décrit pour l'étape 110. De plus, pour simplifier, elles sont supposées constantes. Ainsi, lors de la phase 114, les matrices $R_k$ et $Q_k$ de covariance à l'instant k sont égales, respectivement, aux matrices $R_0$ et $Q_0$ quel que soit l'instant k.

Ensuite, lors d'une étape 120, le calculateur 44 calcule une prédiction $SÔC_{k/k-1}$ et une prédiction $V_{Diff,k/k-1}$ de, respectivement, l'état de charge de la cellule 18 et la tension $V_{Diff,k}$ aux bornes du circuit RC à l'instant k. Dans les notations utilisées ici, l'indice k/k-1 indique que cette prédiction est faite en prenant en compte seulement les mesures réalisées entre les instants 0 et k-1. On parle alors de prédiction a priori. L'indice k/k indique que la prédiction à l'instant k prend en compte l'ensemble des mesures réalisées entre les instants 0 et k. On parle alors de prédiction a posteriori. Les prédictions $SÔC_{k/k-1}$ et $V_{Diff,k/k-1}$ sont calculées à l'aide du modèle 116, de l'intensité mesurée $i_{k-1}$ et de la capacité $C_n^{ini}$.

Lors d'une étape 122, le calculateur 44 calcule également la prédiction $P_{k/k-1}$ d'une matrice de covariance d'erreur d'estimation sur le vecteur d'état $x_k$. Le vecteur d'état xk est ici le vecteur $[SOC_k ; V_{Diff,k}]^T$. Typiquement, cela est réalisé à l'aide de la relation suivante :

$$P_{k/k-1} = F_{k-1}P_{k-1/k-1}F_{k-1}^T + Q_{k-1}$$

$F_{k-1}$ est la matrice de transition d'état à l'instant k-1. Dans le modèle 116, la matrice de transition d'état est constante. Les matrices $P_{k-1/k-1}$ et $Q_{k-1}$ ont déjà été précédemment définies.

Ensuite, lors d'une étape 124, le calculateur construit une matrice $H_k$ en linéarisant le modèle 118 autour des prédictions $\hat{SOC}_{k/k-1}$ et $V_{Diff,k/k-1}$. En effet, le modèle 118 est non linéaire, car la fonction $OCV(SOC_k)$ est généralement non linéaire. À cause de cela, le calculateur implémente la version étendue du filtre de Kalman. Dans cette version étendue, on se ramène à un modèle linéaire d'observation de la forme $y_k = H_k x_k + RO^{ini} * i_k + v_k$ en linéarisant le modèle 118 au voisinage du vecteur $x_k$. Typiquement, le modèle 118 est développé en série de Taylor au voisinage du vecteur $x_k$. Puis on néglige les contributions des dérivées à partir du second ordre. Ici, la matrice $H_k$ est donc égale à la dérivée première de la fonction OCV au voisinage de l'état de charge $SOC_k$. Cette linéarisation du modèle 118 est typiquement réalisée pour chaque nouvelle valeur de l'état de charge $SOC_k$.

Après cela, lors d'une étape 126, le calculateur corrige les prédictions $\hat{SOC}_{k/k-1}$ et $V_{Diff,k/k-1}$ en fonction d'un écart entre la valeur mesurée $y_k$ et une valeur $\hat{y}_k$ prédite à partir du modèle 118. Cet écart est connu sous le nom de « innovation ». Cette étape 126 comprend typiquement :

- une opération 128 de calcul de la prédiction $\hat{y}_k$, puis
- une opération 130 de correction des prédictions $\hat{SOC}_{k/k-1}$ et $V_{D,k/k-1}$ et de la matrice $P_{k/k-1}$ pour obtenir les prédictions corrigées $\hat{SOC}_k k$, $V_{Diff,k/k}$ et $P_{k/k}$.

Lors de l'opération 128, la prédiction $\hat{y}_k$ est calculée à l'aide du modèle 118 dans lequel la valeur de l'état de charge est prise égale à $\hat{SOC}_{k/k-1}$ et la valeur de la tension $V_{Diff,k}$ est prise égale à $V_{D,k/k-1}$. L'écart entre la valeur mesurée $y_k$ et sa prédiction $\hat{y}_k$ est notée $E_k$ par la suite.

De nombreuses méthodes existent pour corriger les estimations à priori $\hat{SOC}_{k/k-1}$ et $V_{Diff,k/k-1}$ à partir de l'innovation $E_k$. Par exemple, lors de l'opération 130, ces estimations sont corrigées à l'aide du gain de Kalman $K_k$. Le gain $K_k$ est donné par la relation suivante $K_k = P_{k/k-1}H^T_k (H_k P_{k/k-1} H^T_k + R_k)^{-1}$. Ensuite, les prédictions a priori sont corrigées à l'aide de la relation suivante : $x_{k/k} = x_{k/k-1} + K_k E_k$.

La matrice $P_{k/k-1}$ est corrigée à l'aide de la relation suivante : $P_{k/k} = P_{k/k-1} - K_k H_k P_{k/k-1}$.

Enfin, lors d'une étape 132, l'estimation prédite et corrigée $SOC_k$, l'intensité mesurée $i_k$ et la valeur mesurée $y_k$ sont enregistrées dans une table particulière de la base 71 de données.

Les étapes 120 à 132 sont réitérées $K_{114}$ fois et, de préférence, à chaque instant k successif. $K_{114}$ est de préférence strictement supérieur à Nh+Mh+1 et, typiquement, supérieur à cinquante. Généralement $K_{114}$ est inférieur à 1000 de façon à ne pas faire durer trop longtemps la phase 114. Ici, $K_{114}$ est pris égal à 100. Ainsi, la phase 114 est exécutée pendant environ 1min et 40s avant que la base 71 contienne assez de données pour déterminer les coefficients du filtre $h_{t,k2}$. Lors de chaque nouvelle itération des étapes 120 à 132, le vecteur d'état $x_{k-1}$ est initialisé avec les valeurs obtenues lors de la précédente itération de la phase 114 pour la cellule 18.

Une fois que le nombre de données stockées dans la base 71 est jugé suffisant, le calculateur 44 déclenche à un instant k2 l'exécution de l'estimateur 66. Dès lors, lors d'une phase 140, le calculateur 44 met à jour les coefficients du filtre $h_{t,k2}$.

Lors d'une étape 142, le calculateur 44 initialise les valeurs des coefficients $a_{i,k2-1}$ et $b_{i,k2-1}$ du filtre $h_{t,k2-1}$ estimé à l'instant k2-1 à des valeurs prédéterminées s'il s'agit de la première exécution de la phase 140. Si la phase 140 a déjà été exécutée, les coefficients $a_{i,k2-1}$ et $b_{i,k2-1}$ sont initialisés avec leurs valeurs obtenues à l'issue de l'exécution de la phase 140 à l'instant k2-1.

Lors de l'étape 142, le calculateur 44 initialise également une matrice de covariance $P_{RLS,k2-1}$. Lors de la première exécution de la phase 140, les coefficients de cette matrice $P_{RLS,0}$ sont pris égaux à des valeurs pré-enregistrées dans la mémoire 42. Par exemple, les valeurs des coefficients de cette matrice sont pris égaux à $10^6$ pour indiquer que l'incertitude sur la valeur initiale des coefficients $a_{i,k2-1}$ et $b_{i,k2-1}$ est maximale. Lors des itérations suivantes de la phase 140, les coefficients de la matrice $P_{RLS,k2-1}$ sont pris égaux aux coefficients de cette matrice obtenus à l'instant k2-1.

Lors d'une étape 144, à l'instant k2, l'estimateur 66 acquiert le vecteur $X_{k2}$. Dans ce vecteur $X_{k2}$, les intensités $i_k$ à $i_{k-Nh}$ et les tensions $V_{D,k-1}$ à $V_{D,k-Mh}$ sont obtenues à partir des données enregistrées dans la base 71 en prenant comme instant k l'instant le plus proche de l'instant k2. Par exemple, lors de l'étape 144, k est pris égal à k2. Plus précisément, la tension $V_{D,k-1}$ est obtenue à partir de la différence entre la valeur mesurée $y_{k-i}$ et la tension à vide $OCV(SOC_{k-i})$, ou la valeur mesurée $y_{k-i}$ et l'état des charges $SOC_{k-i}$ sont des données enregistrées dans la base 71 pour l'instant k-i. Lors de cette étape, l'estimateur 66 acquiert également l'intensité mesurée $ik$ et la valeur mesurée $y_k$.

Lors d'une étape 146, l'estimateur 66 calcule un gain $K_{RLS,k2}$. Par exemple, ce gain est calculé à l'aide de la relation suivante :

$$K_{RLS,k2} = (X_{k2}{}^T * P_{RLS,k2-1})/(\lambda_{RLS} + X_{k2}{}^T * P_{RLS,k2-1}),$$

où le coefficient $\lambda_{RLS}$ est une constante prédéterminée connue sous le terme de « facteur d'oubli ». Cette constante est comprise entre 0 et 1. Ici, $\lambda_{RLS}$ est choisi supérieur ou égal à 0,9. Par exemple, $\lambda_{RLS}$ est égal à 0,99.

Lors d'une étape 148, l'estimateur 66 calcule une prédiction $Vp_{D,k2}$ de la tension $V_{D,k2}$ à l'aide de la relation suivante : $Vp_{D,k2} = h_{t,k2-1}^T * X_{k2}$.

Ensuite, lors d'une étape 150, l'estimateur 66 calcule l'écart $e_{RLS,k2}$ entre la tension mesurée $V_{D,k2}$ et sa valeur prédite $Vp_{D,k2}$. La tension mesurée $V_{D,k2}$ est obtenue à partir de la différence $y_{k2} - OCV(SOC_{k2})$, où la valeur mesurée $y_{k2}$ est la valeur acquise lors de l'étape 144.

Lors d'une étape 152, l'estimateur 66 corrige les valeurs des anciens coefficients $a_{i,k2-1}$ et $b_{i,k2-1}$ pour obtenir des nouveaux coefficients $a_{i,k2}$ et $b_{i,k2}$ qui minimisent encore mieux l'écart $e_{RLS,k2}$. Le filtre avec les coefficients $a_{i,k2}$ et $b_{i,k2}$ est noté $h_{t,k2}$. Par exemple, les nouveaux coefficients $a_{i,k2}$ et $b_{i,k2}$ sont déterminés à l'aide de la relation suivante : $h_{t,k2} = h_{t,k2-1} + K_{RLS,k2} * e_{RLS,k2}$.

Enfin, lors d'une étape 154, la matrice de covariance $P_{RLS,k2-1}$ est mise à jour pour obtenir la nouvelle matrice $P_{RLS,k2}$. Par exemple, cela est réalisé à l'aide de la relation suivante : $P_{RLS,k2} = (P_{RLS,k2-1} - K_{RLS,k2} * X_{k2}^T * P_{RLS,k2-1}) / \lambda_{RLS}$.

Les étapes 142 à 154 sont réitérées $K_{140}$ fois d'affilée pour obtenir une bonne estimation des coefficients du filtre $h_{t,k2}$. Par exemple, ces étapes sont réitérées à chaque instant k compris entre l'instant k et l'instant $k+K_{140}$. Ici, $K_{140}$ est supérieur à 50 et généralement inférieur à 1000. Par exemple, $K_{140}$ est égal à 100. Typiquement, les itérations des étapes 142 à 154 s'arrêtent lorsque l'une des conditions suivantes est satisfaite :

- $K_{140} \geq 50$ et $P_{RLS,k} \leq S_{PRLS}$, ou
- $K_{140} = 100$.

Le seuil $S_{PRLS}$ est un seuil prédéterminé sur la covariance de l'erreur d'estimation des coefficients $a_{i,k2}$ et $b_{i,k2}$.

Lorsque l'itération des étapes 142 à 154 cesse, l'exécution de l'estimateur 60 est déclenchée, ce qui déclenche l'exécution d'une phase 160 d'estimation de l'état de charge $SOC_k$. En parallèle, la phase 114 est arrêtée. En effet, l'estimateur 60 donne une estimation de l'état de charge $SOC_k$ plus précise que celle obtenue par l'algorithme d'estimation mis en oeuvre lors de la phase 114.

Pour estimer l'état de charge $SOC_k$, l'estimateur 60 utilise systématiquement les dernières valeurs connues pour les coefficients du filtre $h_{t,k2}$ et de la capacité $C_{n,k3}$. Ainsi, tant qu'aucune capacité $C_{n,k3}$ n'a été estimée par l'estimateur 68, c'est la capacité $C_n^{ini}$ qui est utilisée. Le fonctionnement de la phase 160 se déduit de l'enseignement précédent et de celui contenu dans les précédents articles qui traitent des filtres de Kalman à points Sigma. Par conséquent, cette phase 160 n'est pas décrite en détail. La phase 160 comporte notamment :

- une étape 162 de calcul d'une prédiction $\hat{SOC}_{k/k-1}$ de l'état de charge de la cellule 18 à l'aide du modèle 62, puis
- une étape 164 de calcul d'une prédiction $\hat{y}_k$ de la valeur mesurée $y_k$ à l'aide du modèle 64, puis
- la correction, lors d'une étape 166, de la prédiction $\hat{SOC}_{k/k-1}$ pour obtenir l'état de charge prédit et corrigé $\hat{SOC}_{k/k}$ à partir de l'écart entre la valeur prédite $\hat{y}_k$ et la valeur mesurée $y_k$. Par exemple, la phase 160 est exécutée à chaque instant k à partir du moment où l'exécution de l'estimateur 60 est déclenchée.

Également en parallèle des phases 112, 114, 140 et 160, le procédé comporte une étape 180 lors de laquelle à chaque instant k, l'état de charge $SOC_k$ est comparé à un seuil haut prédéterminé $SH_{soc}$. Si l'état de charge $SOC_k$ descend en dessous de ce seuil $SH_{soc}$, alors le procédé se poursuit immédiatement par des étapes 182 et 184. Dans le cas contraire, l'étape 180 est réitérée au prochain instant k. Typiquement, le seuil $SH_{soc}$ est compris entre 90 % et 100 %.

Lors de l'étape 182, le calculateur 44 commence par initialiser un compteur à zéro puis l'incrémente de 1 à chaque nouvelle mesure de l'intensité $i_k$ depuis le début de cette étape. De plus, à chaque instant k, l'intensité mesurée $i_k$ et l'état de charge $SOC_k$ généré au même instant sont enregistrés, associés à cet instant k, dans la base 71 de données.

En parallèle de l'étape 182, lors de l'étape 184, le calculateur 44 compare chaque nouvelle état de charge $SOC_k$ à un seuil prédéterminé $SL_{soc}$. Le seuil $SL_{soc}$ est par exemple compris entre 0 % et 10 %. Tant que l'état de charge $SOC_k$ reste supérieure à ce seuil $SL_{soc}$, l'étape 182 est réitérée à l'instant k suivant. Dans le cas contraire, dès que l'état de charge $SOC_k$ pour la cellule 18 descend en dessous de ce seuil $SL_{soc}$ alors, le calculateur 44 déclenche immédiatement l'exécution de l'estimateur 68 et arrête d'incrémenter le compteur. Ainsi, tant que ce seuil $SL_{soc}$ n'est pas franchi, l'exécution de l'estimateur 68 est inhibée.

L'estimateur 68 estime, lors d'une phase 188, la capacité $C_{n,k3}$ à l'instant k3. L'instant k3 est donc égal à l'instant k où l'exécution de l'estimateur 68 est déclenchée.

Comme pour la phase 140, étant donné que l'estimateur 68 n'est pas exécuté à chaque instant k, l'instant k3-1 ne correspond pas à l'instant k-1. Au contraire, les instants k3 et k3-1 sont séparés par un intervalle de temps supérieur ou égal à $NT_e$ où N est le nombre compté lors de l'étape 182.

Les paramètres du filtre de Kalman de l'estimateur 68 sont initialisés avec les valeurs précédentes de ces paramètres obtenus à l'issue de la précédente itération à l'instant k3-1 de la phase 188.

La phase 188 comprend :

- le calcul, lors d'une étape 190, de la prédiction $C_{n,k3/k3-1}$ à l'aide du modèle 74,
- le calcul, lors d'une étape 192, de la prédiction $P_{3,k3/k3-1}$ de la matrice de covariance de l'erreur d'estimation de la capacité, et
- la correction, lors d'une étape 194, des prédictions $C_{n,k3/k3-1}$ et $P_{3,k3/k3-1}$.

Lors de l'étape 190, l'estimateur 68 utilise la dernière fonction $f_{SVM}$ apprise. Initialement, il s'agit donc de la fonction $f_{SVM}$ apprise lors de l'étape 102. Par contre, si depuis la machine 70 a exécuté un nouveau cycle d'apprentissage, alors c'est cette dernière fonction apprise qui est utilisée par l'estimateur 68. Par exemple, pour connaître la valeur de la fonction $f_{SVM}(Ec)$ à l'instant k3, les paramètres de l'ensemble Ec mesurés à l'instant k3 sont transmis à la machine 70 qui, en réponse, renvoie à l'estimateur 68 la valeur de la fonction $f_{SVM}(Ec)$ à l'instant k3. Dans ce mode de réalisation, la machine 70 acquière la valeur mesurée $y_{k3}$ et l'intensité mesurée $i_{k3}$. Lors de l'étape 190, la machine 70 fonctionne dans son mode d'utilisation.

Lors des étapes 192 et 194, la matrice d'observabilité H3,k3 est égale à $[(SOC_k - SOC_{k-N})]*3600/(NT_e)$. N est ici le nombre d'instants k écoulés entre l'instant où l'état de charge estimé est descendu en dessous du seuil $SH_{soc}$ et l'instant où l'état de charge estimé est descendu en dessous du seuil $SL_{soc}$. La valeur N est égale à la valeur comptée lors de l'étape 182.

L'étape 194 comprend une opération 196 d'acquisition de la grandeur physique mesurée $z_{k3}$ et de calcul de la prédiction $\hat{z}_{k3}$ de la grandeur $z_{k3}$. L'acquisition de la grandeur $z_{k3}$ consiste ici à calculer la somme des N dernières intensités mesurées entre les instants k-1 et K-N. La prédiction $\hat{z}_{k3}$ est obtenue à partir du modèle 76.

Ensuite, lors d'une opération 198, l'estimateur 68 corrige la prédiction $C_{n,k3/k3-1}$ en fonction de l'écart entre la grandeur mesurée $z_{k3}$ et la grandeur prédite $\hat{z}_{k3}$ pour obtenir l'estimation à posteriori de la capacité $C_{n,k3/k3}$. Cette correction est par exemple réalisée comme décrit lors de l'opération 130.

Ensuite, la capacité $C_{n,k3/k3}$ est transmise à l'estimateur 60 qui l'utilise pour estimer l'état de charge de la cellule 18 aux instants suivants. En même temps, l'intensité $i_{k3}$, la valeur mesurée $y_{k3}$ et la capacité $C_{n,k3/k3}$ sont enregistrées dans la base 71 de données.

Le fait de déclencher l'exécution de l'estimateur 68 uniquement après que la cellule 18 se soit en grande partie déchargée permet d'accroître la précision de l'estimation tout en diminuant en même temps la puissance de calcul nécessaire pour mettre en oeuvre ce procédé.

À l'issue de la phase 188, lors d'une étape 200, le calculateur calcule l'état de santé $SOH_{k3}$ à l'instant k3 à l'aide de la formule suivante : $SOH_{k3} = C_{n,k3}/C_n^{ini}$.

Le procédé comporte également une étape 210 lors de laquelle le calculateur 44 vérifie si au moins une condition pour déclencher automatiquement une nouvelle phase 212 d'apprentissage de la fonction $f_{SVM}$ est remplie. Par exemple, une nouvelle exécution de la phase 212 est automatiquement déclenchée dès que la covariance de l'erreur d'estimation de la capacité $C_{n,k3}$ dépasse un seuil prédéterminé $S_{PC}$. La phase 212 est déclenchée à l'instant k4. L'ensemble des instants k4 auquel la phase 212 est déclenchée est un sous-ensemble des instants k3. Lors de la phase 212, la machine 70 fonctionne en mode d'apprentissage. Plus précisément, la machine 70 exécute à nouveau l'algorithme d'apprentissage supervisé en prenant en compte les intensités $i_{k3}$, les valeurs mesurées $y_{k3}$ et les capacités $C_{n,k3}$ prédites et corrigées par l'estimateur 68 aux précédents instants k3. Par exemple, la machine 70 prend uniquement en compte les données enregistrées dans la base 71 depuis le précédent instant k4-1 d'exécution de la phase 212. Une fois l'apprentissage de la nouvelle fonction $f_{SVM}$ terminé, c'est cette nouvelle fonction qui est utilisée par l'estimateur 68.

En parallèle, lors d'une étape 220, le calculateur 44 compare chaque nouvelle mesure de l'intensité $i_k$ à un seuil $SH_i$ de courant prédéterminé. Tant que l'intensité mesurée ne dépasse pas ce seuil $SH_i$, l'exécution de l'estimateur 66 et inhibée. À l'inverse, dès que l'intensité ik mesurée dépasse ce seuil $SH_i$, alors l'estimateur 66 est immédiatement exécuté. Le seuil $SH_i$ est généralement supérieur à $I_{max}/2$ et, avantageusement supérieur à $0,8*I_{max}$ ou $0,9*I_{max}$.

L'estimateur 66 exécute alors à nouveau la phase 140 d'estimation des coefficients du filtre $h_{t,k2}$ à l'instant k2. Ici, l'instant k2 est égal à l'instant k où l'intensité $i_k$ franchit le seuil $SH_i$.

Le fait de déclencher l'exécution de l'estimateur 66 uniquement lorsque l'intensité mesurée ik est élevée permet d'accroître la précision de l'estimation des coefficients du filtre $h_{t,k2}$ tout en diminuant en même temps la puissance de calcul nécessaire pour mettre en oeuvre ce procédé. En effet, la précision de la mesure de l'ampèremètre est plus élevée lorsque l'intensité ik est plus élevée.

De nombreux autres modes de réalisation du procédé d'estimation de l'état de charge d'une cellule sont possibles. Par exemple, d'autres modèles électriques et donc d'autres modèles d'état peuvent être utilisés pour estimer l'état de charge de la cellule 18. Par exemple, dans une variante simplifiée, l'impédance 54 est modélisée à l'aide d'un filtre à réponse impulsionnelle fini. Cela revient dans la description précédente à prendre Mh égal à zéro. Dans ce cas, en général, Nh est choisi supérieur au égal à 10. Par exemple, Nh est choisi égal à 15. D'autres modèles d'état possibles sont décrits dans la demande WO2006057468. En particulier, le vecteur d'état $x_k$ peut aussi être complété par la température de la cellule 18 de manière à estimer cette température en même temps que l'état de charge de cette cellule.

D'autres modèles d'observation sont également possible pour l'estimateur 60. Par exemple, la cellule 18 est équipée d'un capteur supplémentaire tel qu'un capteur de température. Dans ce cas, le modèle d'observation est modifié pour tenir compte de ces grandeurs physiques mesurées supplémentaires. Le lecteur peut se référer à la demande WO2006057468 pour des exemples de modèles d'observation modifiés. Si le modèle d'observation utilisé n'utilise pas le filtre $h_{t,k2}$, alors l'estimateur 66 est omis.

D'autres modèles électriques possibles pour modéliser la cellule 18 sont également présentés dans la partie 2 de Plett 2004, au chapitre 3.3.

L'estimateur 60 peut aussi implémenter la version étendue du filtre de Kalman plus connue sous l'acronyme EKF (Extended Kalman Filter) au lieu de la version à points Sigma. L'estimateur 60 peut aussi être implémenté sous une autre forme qu'un filtre de Kalman. Par exemple, l'état de charge est estimé en modélisant son évolution au cours du temps sous la forme d'un filtre RII (Réponse Impulsionnelle Infinie) dont les coefficients sont estimés par la méthode RLS (Recursive Least Square).

Dans une variante de l'estimateur 60, les matrices de covariance $R_k$ et $Q_k$ sont ajustées automatiquement en continu. Pour cela, par exemple, la méthode dite de « Covariance Matching » décrite dans l'article suivant est appliquée : Mehra, R.K : « On the identification of variances and adaptive Kalman Filtering », Automatic Control, IEEE Transaction on, Volume 15, n°2, pages 175-184, avril 1970. Cette méthode s'applique après un réglage initial des matrices $R_0$ et $Q_0$, par exemple, comme décrit lors de l'étape 110.

De même, l'étape de correction de la prédiction peut être réalisée différemment. Par exemple, la correction de la prédiction de l'état de charge SOCk ou de la capacité $C_{n,k3}$ est réalisée en minimisant une fonction de coût J quadratique qui comporte deux termes :

- un terme lié à l'erreur de prédiction de la valeur mesurée, et
- un autre terme lié à l'erreur d'estimation du vecteur d'état.

Cette méthode est décrite en détail au chapitre 10.5.2 du livre suivant : Y. Bar-Shalom, et Al. : « Estimation with Applications to Tracking and Navigation, Theory Algorithms and Software », Wiley Inter-science, 2001.

En variante, l'estimateur 60 n'est pas nécessairement exécuté à chaque instant k. Dans ce cas, l'estimateur 60 récupère les informations nécessaires pour cette exécution à partir des valeurs obtenues à l'issue de sa précédente exécution. C'est notamment le cas par exemple pour les variables d'état. On notera cependant que l'instant d'exécution précédent n'est alors pas nécessairement l'instant k-1 mais peut être un instant k-3 ou k-10.

L'estimateur 66 peut utiliser d'autres algorithmes pour déterminer les coefficients du filtre ht,k2. Ainsi, en variante, l'estimateur implémente une autre variante de l'algorithme des moindres carrés récursifs connu sous l'acronyme RLS-GSW (Recursive Least Square - Global Sliding Window). Il peut aussi implémenter l'algorithme récursif utilisé dans l'article suivant pour estimer la capacité d'une cellule d'une batterie : Gregory L. Plett, « Recursive approximate weighted total least squares estimation of battery cell total capacity », Journal of Power Sources 196 (2011) 2319-2331. Il est aussi possible d'incorporer les coefficients du filtre $h_{t,k2}$ au vecteur d'état du modèle d'état puis d'utiliser un filtre de Kalman pour estimer ces coefficients en même que l'état de charge est estimé. Dans ce dernier cas, le modèle d'état 62 est remplacé par le modèle d'état suivant :

$$
\begin{bmatrix} SoC_{k+1} \\ b_0 \\ b_1 \\ \vdots \\ b_N \\ a_1 \\ \vdots \\ a_M \end{bmatrix}
=
\begin{bmatrix} SoC_k + \frac{i_k \Delta T}{C_n} \\ b_0 \\ b_1 \\ \vdots \\ b_N \\ a_1 \\ \vdots \\ a_M \end{bmatrix}
+
\begin{bmatrix} w_k \\ w_{k_0} \\ w_{k_1} \\ \vdots \\ w_{k_N} \\ w_{k_{N+1}} \\ \vdots \\ w_{k_{N+M}} \end{bmatrix}
$$

où : $b_0$ à $b_N$ et $a_1$ à $a_M$ sont les coefficients du filtre $h_{t,k2}$ et correspondent, respectivement, aux coefficients $b_{0,k2}$ à $b_{Nh,k2}$ et $a_{1,k2}$ à $a_{Mh,k2}$ précédemment décrits. Dans ce dernier cas, le modèle d'observation est inchangé. Il s'agit donc du modèle 64. Dans cette variante, les coefficients $b_0$ à $b_N$ et $a_1$ à aM sont estimés à chaque instant k. Toutefois, le modèle 62 peut aussi être remplacé par le modèle d'état ci-dessus uniquement aux instants k2 et, entre deux instants k2 successifs, c'est le modèle 64 qui est utilisé.

Des coefficients initiaux $a_{i,0}$ et $b_{i,0}$ du filtre $h_{t,0}$ peuvent être déterminés en laboratoire par des expérimentations sur une cellule identique à la cellule 18 par exemple. Ensuite, lors de la phase 100 d'initialisation, les coefficients $a_{i,0}$ et $b_{i,0}$ déterminés en laboratoire sont enregistrés dans la mémoire 42 avant même la première activation du système 40. Ainsi, dès la première exécution du procédé de la figure 8, l'estimateur 60 peut être exécuté en utilisant ces coefficients $a_{i,0}$ et $b_{i,0}$ préenregistrés. Dans ce cas, la phase 114 est omise.

L'exécution de l'estimateur 66 peut être déclenchée différemment. Par exemple, l'exécution de l'estimateur 66 est déclenchée périodiquement. Dans ce cas, l'étape 220 est omise.

Selon le modèle d'observation utilisé par l'estimateur 68, la grandeur $z_{k3}$ peut être calculée différemment. Par exemple, la grandeur $z_{k3}$ est égale à la somme des N dernières intensités mesurées entre les instants k et k-N+1. Dans ce cas, lorsque N est égal à 1, $z_{k3} = i_{k3}$.

En variante, la fonction $G_{SVM}(C_{n,k3-1} ; Ec)$ n'est pas écrite sous la forme $C_{n,k3-1} + f_{svm}(Ec)$. Dans ce cas, la fonction $G_{SVM}(C_{n,k3-1} ; Ec)$ n'est généralement pas une fonction linéaire de la capacité $C_{n,k3}$. L'estimateur 68 est alors implémenté, par exemple, sous la forme d'un filtre de Kalman étendue (« Extended Kalman Filter » en anglais) ou d'un filtre de Kalman à points Sigma.

Le déclenchement de l'estimateur 68 peut être simplifié en prenant N égal à une constante prédéterminée. Dans ce cas, N n'est pas compté et les étapes 180 et 182 sont omises. Par exemple, N est choisi égale à un ou, au contraire, strictement supérieur à 1 ou 5 ou 10. Dans une variante encore plus simplifiée, le déclenchement de l'estimateur 68 en réponse au franchissement d'un seuil est omis. Par exemple, l'estimateur 68 est déclenché périodiquement. Dans ce cas, les étapes 180, 182 et 184 sont omises.

En variante, les covariances $Q_{3,0}$ et $R_{3,0}$ de l'estimateur 68 sont réglées en fonction de l'incertitude sur la fonction $f_{SVM}$ construite par la machine 70 et obtenue à l'issue de l'étape 102.

Lors de la phase 212 d'apprentissage, les caractéristiques physiques de l'ensemble Ec ne sont pas nécessairement les mêmes que celles utilisées lors de l'étape 102 d'apprentissage initial.

Dans une autre variante, la fonction $f_{SVM}$ est apprise par une machine d'apprentissage mécaniquement indépendant du véhicule 2 et de la cellule 18. Par exemple, cette autre machine d'apprentissage est exécutée dans un laboratoire. Ensuite, la fonction $f_{SVM}$ apprise par cette autre machine est enregistrée dans la mémoire 42 puis utilisée par la machine 70 en tant que fonction $f_{SVM}$ initiale même si cette fonction n'a pas été apprise par la machine 70. L'autre machine d'apprentissage est par exemple identique à la machine 70. Dans ce cas, la machine 70 n'est pas utilisée pour apprendre la fonction $f_{SVM}$ initiale et l'étape 102 d'apprentissage initial est omise.

Dans une variante simplifiée, la phase 212 d'apprentissage est omise. Ainsi, dans ce mode de réalisation, la fonction $f_{SVM}$ n'est jamais réapprise au cours de l'utilisation du système 40. La machine 70 fonctionne donc uniquement en mode d'utilisation après l'étape 102 d'apprentissage initial. Dans une variante encore plus simplifiée, en plus d'omettre la phase 212, la fonction $f_{SVM}$ apprise initialement n'est pas apprise à l'aide de la machine 70 mais l'une autre machine d'apprentissage supervisé indépendante du véhicule 2. L'étape 102 comporte alors seulement l'enregistrement dans la mémoire 42 de cette fonction $f_{SVM}$ apprise par une autre machine. Dans ce cas, la machine 70 est considérablement simplifiée puisqu'elle n'a pas à implémenter l'algorithme d'apprentissage supervisé. Elle fonctionne uniquement en mode d'utilisation.

Dans un autre mode de réalisation, l'étape 102 d'apprentissage initial est omise. Dès lors, tant que la fonction $f_{SVM}$ n'a pas été apprise par la machine 70, l'estimateur 68 utilise un autre algorithme d'estimation de la capacité. Par exemple, il peut utiliser un algorithme RLS tel que cela est décrit dans l'article suivant : Gregory L. Plett, « Recursive Approximate Weighted Total Least Squares Estimation of Battery Cell Total Capacity », Journal of Power Source, 196 (2011), 2319-2331. Il peut aussi utiliser un autre filtre de Kalman dans lequel le modèle d'état ne fait pas intervenir la fonction $f_{SVM}$. Par exemple, dans ce dernier cas, le modèle d'état peut être le suivant $C_{n,k3+1} = C_{n,k3} + w_{3,k3}$.

La batterie 10 peut être remplacée par tout type de batterie, comme par exemple, une batterie au plomb, une super-capacité ou une pile à combustible. Dans ce cas, le modèle d'état et/ou le modèle d'observation de l'estimateur 60 peuvent éventuellement être adaptés pour tenir compte de la technologie de la batterie.

Ce qui a été décrit précédemment s'applique aussi au véhicule hybride, c'est-à-dire au véhicule dont l'entraînement des roues motrices est à la fois ou, en alternance, assuré par un moteur électrique et un moteur thermique à combustion interne. Le véhicule 2 peut aussi être un camion, une moto ou un tricycle et de façon générale, tout véhicule capable de se déplacer en entraînant des roues motrices à l'aide d'un moteur électrique alimenté par une batterie. Par exemple, il peut s'agir d'un monte-charge.

La batterie 10 peut être rechargée par l'intermédiaire d'une prise électrique qui permet de la raccorder électriquement à un réseau de distribution d'électricité. La batterie 10 peut aussi être rechargée par un moteur thermique à combustion interne.

Enfin, le procédé d'estimation des coefficients du filtre $h_{t,k2}$ décrit ci-dessus peut être mis en oeuvre indépendamment de la machine d'apprentissage 70. Par exemple, la fonction $f_{SVM}$ est omise du modèle d'état 74. Dans ce cas, l'estimateur 68 utilise seulement le modèle d'état suivant $C_{n,k3+1} = C_{n,k3} + w_{3,k3}$ et la machine 70 est omise. L'estimateur 68 n'est pas non plus nécessairement implémenté sous la forme d'un filtre de Kalman. Par exemple, la capacité est estimée en modélisant son évolution au cours du temps sous la forme d'un filtre RII (Réponse Impulsionnelle Infinie) dont les coefficients sont estimés par la méthode RLS (Recursive Least Square). Dans une variante encore plus simplifiée, la capacité $C_{n,k3}$ n'est pas estimée. Par exemple, elle est prise constante et égale à la capacité $C_n^{ini}$.

## Revendications

1. Procédé automatique d'estimation de la capacité d'une cellule d'une batterie, ce procédé comportant :

   a) l'acquisition (112), à un instant k, d'une intensité mesurée $i_k$ du courant de charge ou de décharge de la cellule,
   b) l'estimation (188) de la capacité $C_{n,k3}$ de la cellule à un instant k3 en utilisant un filtre de Kalman, cette estimation comportant :

   • le calcul (190) d'une prédiction de la capacité $C_{n,k3}$ à l'aide d'un modèle d'état qui relie la capacité $C_{n,k3}$ à la capacité $C_{n,k3-1}$ de cette même cellule à un instant précédent k3-1, puis
   • l'acquisition (196), à l'instant k3, d'une grandeur physique mesurable $z_{k3}$ définie par la relation suivante :

$$z_{k3} = \sum_{m=k-N}^{m=k-1} i_m$$

   où k est l'instant le plus proche de l'instant k3 et N est un entier supérieur ou égal à un, $z_{k3}$ étant égale à $i_{k-1}$ lorsque N est égal à un,
   • le calcul (196) d'une prédiction $\hat{z}_{k3}$ de la grandeur physique mesurable $z_{k3}$ à l'aide d'un modèle d'observation, et
   • la correction (198) de la prédiction de la capacité $C_{n,k3}$ en fonction de l'écart entre la grandeur physique acquise $z_{k3}$ et la prédiction $\hat{z}_{k3}$ calculée à partir du modèle d'observation,
   le procédé comporte également :

   - l'apprentissage automatique (102, 212) d'une fonction $G_{SVM}$ qui renvoie la capacité $C_{n,k3}$ en fonction de la capacité $C_{n,k3-1}$ et d'au moins une caractéristique physique $cc_{1,k3}$ corrélée à l'évolution temporelle de la capacité de la cellule et mesurée à l'instant k3, cet apprentissage automatique comportant l'exécution (108) d'un algorithme d'apprentissage supervisé sur une base de données d'apprentissage, cette base de données d'apprentissage contenant des valeurs de la capacité et, pour chaque valeur de la capacité, la valeur de la caractéristique physique mesurée au même instant et la valeur précédente de la capacité, et
   - une fois que la fonction $G_{SVM}$ est apprise, lors de l'exécution de l'étape b) à un instant k3+1 ultérieur, le calcul (190) de la prédiction de la capacité $C_{n,k3+1}$ utilise le modèle d'état défini par la relation suivante $C_{n,k3+1} = G_{SVM}(C_{n,k3}, CC_{1,k3+1})$.

2. Procédé selon la revendication 1, dans lequel la fonction $G_{SVM}(C_{n,k3-1}, cc_{1,k3})$ est définie par la relation suivante : $G_{SVM}(C_{n,k3-1}, cc_{1,k3}) = C_{n,k3-1} + f_{svm}(cc_{1,k3})$, où $f_{svm}(cc_{1,k3})$ est une fonction apprise lors de l'étape d'apprentissage à partir des données enregistrées dans la base de données d'apprentissage.

3. Procédé selon la revendication 1 ou 2, dans lequel :

   - à chaque instant k3, le procédé comporte l'enregistrement dans la base de données d'apprentissage :

   • de la capacité $C_{n,k3}$ prédite puis corrigée par le filtre de Kalman lors de l'étape b), et
   • de la caractéristique physique $cc_{1,k3}$ mesurée à l'instant k3, puis

   - l'apprentissage automatique (212) de la fonction $G_{SVM}$ comporte l'exécution de l'algorithme d'apprentissage supervisé sur cette base de données d'apprentissage dans laquelle ont été enregistrées les capacités $C_{n,k3}$ prédites puis corrigées par le filtre de Kalman.

4. Procédé selon la revendication 3, dans lequel :

- l'étape b) comporte également l'estimation (194) de la covariance $Pc_{k3}$ de l'erreur d'estimation de la capacité $C_{n,k3}$, et

- l'apprentissage automatique de la fonction $G_{SVM}$ est déclenchée automatiquement (210) en réponse au dépassement d'un seuil prédéterminé par la covariance estimée $Pc_{k3}$.

**5.** Procédé selon l'une quelconque des revendications précédentes, dans lequel le calcul (196) de la prédiction $\hat{z}_{k3}$ est réalisé à l'aide du modèle d'observation suivant :

$$\hat{z}_{k3} = \frac{(SOC_k - SOC_{k-N})}{NT_e} . 3600 . C_{n,k3}$$

où :

- k est l'instant le plus proche de l'instant k3,
- $SOC_k$ et $SOC_{k-N}$ sont les états de charge de la cellule aux instants k et k-N,
- $C_{n,k3}$ est, dans ce modèle d'observation, la prédiction de la capacité de la cellule à l'instant k3 calculée juste avant d'être corrigée, et
- $T_e$ est l'intervalle de temps qui sépare deux instants k et k-1 quelconque.

**6.** Procédé selon l'une quelconque dans revendications précédentes, dans lequel l'algorithme d'apprentissage supervisé est une machine à vecteurs supports.

**7.** Procédé selon l'une quelconque des revendications précédentes, dans lequel le procédé comporte également le calcul (200) de l'état de santé $SOH_{k3}$ de la cellule à l'aide de la relation suivante : $SOH_{k3} = C_{n,k3}/C_n^{ini}$, où :

- $C_{n,k3}$ est la capacité de la cellule estimée à l'instant k3 le plus récent, et
- $C_n^{ini}$ est la capacité initiale de la cellule.

**8.** Procédé automatique d'estimation de l'état de charge d'une cellule d'une batterie, ce procédé comportant :

a) l'acquisition (112), à un instant k, d'une valeur mesurée $y_k$ de la tension entre des bornes de la cellule, et d'une intensité mesurée $i_k$ du courant de charge ou de décharge de la cellule,

b) l'estimation (160) de l'état de charge $SOC_k$ de la cellule, à l'instant k, à partir de la valeur mesurée $y_k$, de l'intensité mesurée ik et d'une capacité $C_{n,k3}$ de la cellule, cette capacité $C_{n,k3}$, exprimée en Ah, représentant la quantité maximale d'énergie électrique stockable dans la cellule à l'instant k3, l'instant k3 étant l'instant auquel la capacité $C_{n,k3}$ a été estimée le plus proche de l'instant k, et

c) l'estimation (188) de la capacité $C_{n,k3}$ à un instant k3, les instants k3 étant moins fréquent que les instants k,

**caractérisé en ce que** l'estimation (188) de la capacité $C_{n,k3}$ à un instant k3 est réalisé selon un procédé conforme à l'une quelconque des revendications précédentes.

**9.** Procédé selon la revendication 8, dans lequel le procédé comporte aussi :

- la mise à jour (140) des coefficients d'un filtre $h_{t,k2+1}$ à réponse impulsionnelle infinie, cette mise à jour comportant :

• le calcul (148) d'une prédiction $Vp_{D,k}$ d'une tension $V_{D,k}$ aux bornes d'une impédance de la cellule à l'aide de la relation suivante :

$$Vp_{D,k} = h_{t,k2} * X_k = \sum_{i=0}^{i=Nh} b_{i,k2} * i_{k-i} - \sum_{i=1}^{i=Mh} a_{i,k2} * V_{D,k-i}$$

où

- $i_{k-i}$ est l'intensité mesurée à l'instant k-i,
- $V_{D,k-1}$ est la tension mesurée aux bornes de l'impédance de la cellule à l'instant k-i,
- $a_{i,k2}$ et $b_{i,k2}$ sont les coefficients du filtre $h_{t,k2}$ mis à jour à l'instant k2 le plus proche de l'instant k, et
- Nh et Mh sont des entiers constants strictement supérieurs à deux,

• le calcul (150) d'un écart $e_{RLS,k}$ entre la valeur mesurée $V_{D,k}$ et sa prédiction $Vp_{D,k}$, où la valeur mesurée $V_{D,k}$ est obtenue à partir de la différence $y_k$_OCV($SOC_k$), où OCV($SOC_k$) est une fonction prédéterminée qui retourne la tension à vide entre les bornes de la cellule pour l'état de charge SOCk de la cellule à l'instant k,
• la correction des coefficients $a_{i,k2}$ et $b_{i,k2}$ pour minimiser l'écart $e_{RLS,k}$, et

- une fois que les coefficients du filtre $h_{t,k2}$ ont été mis à jour, l'estimation (160), lors de l'étape b), de l'état de charge SOCk de la cellule à l'aide d'un filtre de Kalman utilisant le modèle d'observation suivant : $y_k =$ OCV($SOC_k$) - $h_{t,k2}*X_k$, où :

• $h_{t,k2}$ est le filtre à réponse impulsionnelle finie dont les coefficients ont été mis à jour à l'instant k2 le plus proche de l'instant k, et
• $X_k$ est le vecteur suivant $[i_k, ... , i_{k-Nh}, V_{D,k-1}, ... , V_{D,k-Mh}]^T$.

10. Procédé selon la revendication 9, dans lequel le filtre de Kalman utilisé lors de l'étape b) d'estimation (160) de l'état de charge SOCk est un filtre de Kalman à points Sigma.

11. Support (42) d'enregistrement d'informations, comportant des instructions pour l'exécution d'un procédé d'estimation conforme à l'une quelconque des revendications précédentes, lorsque ces instructions sont exécutées par un calculateur électronique.

12. Système de gestion d'une batterie équipé d'au moins une cellule, ce système comportant un calculateur électronique (44) programmé pour :

a) acquérir, à un instant k, une intensité mesurée $i_k$ du courant de charge ou de décharge de la cellule,
b) estimer la capacité $C_{n,k3}$ de la cellule à un instant k3 en utilisant un filtre de Kalman, cette estimation comportant :

• le calcul d'une prédiction de la capacité $C_{n,k3}$ à l'aide d'un modèle d'état qui relie la capacité $C_{n,k3}$ à la capacité $C_{n,k3-1}$ de cette même cellule à un instant précédent k3-1, puis
• l'acquisition, à l'instant k3, d'une grandeur physique mesurable $z_{k3}$ définie par la relation suivante :

$$z_{k3} = \sum_{m=k-N}^{m=k-1} i_m$$

où k est l'instant le plus proche de l'instant k3 et N est un entier supérieur ou égal à un, $z_{k3}$ étant égale à $i_{k-1}$ lorsque N est égal à un,
• le calcul d'une prédiction $\hat{z}_{k3}$ de la grandeur physique mesurable $z_{k3}$ à l'aide d'un modèle d'observation, et
• la correction de la prédiction de la capacité $C_{n,k3}$ en fonction de l'écart entre la grandeur physique acquise $z_{k3}$ et la prédiction $\hat{z}_{k3}$ calculée à partir du modèle d'observation,
le calculateur (44) est également programmé pour :

- apprendre automatiquement une fonction $G_{SVM}$ qui renvoie la capacité $C_{n,k3}$ en fonction de la capacité $C_{n,k3-1}$ et d'au moins une caractéristique physique $cc_{1,k3}$ corrélée à l'évolution temporelle de la capacité de la cellule et mesurée à l'instant k3, cet apprentissage automatique comportant l'exécution d'un algorithme d'apprentissage supervisé sur une base de données d'apprentissage, cette base de données d'apprentissage contenant des valeurs de la capacité et, pour chaque valeur de la capacité, la valeur de la caractéristique physique mesurée au même instant et la valeur précédente de la capacité, et
- une fois que la fonction $G_{SVM}$ est apprise, lors de l'exécution de l'étape b) à un instant k3+1 ultérieur, calculer la prédiction de la capacité $C_{n,k3+1}$ en utilisant le modèle d'état défini par la relation suivante $C_{n,k3+1} = G_{SVM}(C_{n,k3}, cc_{1,k3+1})$.

**13.** Véhicule automobile (2) comportant :

- au moins une roue motrice (6),
- un moteur électrique (4) apte à entraîner en rotation cette roue motrice pour déplacer le véhicule automobile,
- une batterie (10) comportant au moins une cellule (18-21) apte à stocker de l'énergie électrique et, en alternance, à restituer de l'énergie électrique pour alimenter le moteur électrique, cette cellule comportant deux bornes (30, 32) par l'intermédiaire desquelles elle est électriquement raccordée au moteur électrique,
- un voltmètre (34) raccordé électriquement entre les bornes de la cellule pour mesurer la tension entre ces bornes,
- un ampèremètre (36) raccordé en série avec la cellule électrique pour mesurer l'intensité du courant de charge ou de décharge de cette cellule, et
- un système (40) de gestion de la batterie raccordé au voltmètre et à l'ampèremètre, ce système de gestion comportant un calculateur électronique (44) programmable apte à estimer l'état de charge de la cellule de la batterie à partir des mesures du voltmètre et de l'ampèremètre, **caractérisé en ce que** le système (40) de gestion de la batterie est conforme à la revendication 12.

**Patentansprüche**

**1.** Automatisches Verfahren zur Schätzung der Kapazität einer Zelle einer Batterie, wobei dieses Verfahren umfasst:

a) den Erhalt (112) zu einem Zeitpunkt k einer gemessenen Intensität ik des Lade- oder Entladestroms der Zelle,
b) die Schätzung (188) der Kapazität $C_{n,k3}$ der Zelle zu einem Zeitpunkt k3, indem ein Kalman-Filter verwendet wird, wobei diese Schätzung umfasst:

• die Berechnung (190) einer Vorhersage der Kapazität $C_{n,k3}$ mithilfe eines Statusmodells, das die Kapazität $C_{n,k3}$ mit der Kapazität $C_{n,k3-1}$ derselben Zelle zu einem vorangehenden Zeitpunkt k3-1 verknüpft, ferner
• den Erhalt (196) zum Zeitpunkt k3 einer messbaren physikalischen Größe $z_{k3}$, definiert durch nachfolgendes Verhältnis:

$$z_{k3} = \sum_{m=k-N}^{m=k-1} i_m$$

wobei k der Zeitpunkt ist, der dem Zeitpunkt k3 am nächsten ist, und N eine ganze Zahl von größer oder gleich eins ist, wobei $z_{k3}$ gleich $i_{k-1}$ ist, wenn N gleich eins ist,
• die Berechnung (196) einer Vorhersage $\hat{z}_{k3}$ der messbaren physikalischen Größe $z_{k3}$ mithilfe eines Beobachtungsmodells, und
• die Berichtigung (198) der Vorhersage der Kapazität $C_{n,k3}$ entsprechend der Abweichung zwischen der erhaltenen physikalischen Größe $z_{k3}$ und der Vorhersage $\hat{z}_{k3}$, berechnet auf Grundlage des Beobachtungsmodells, wobei das Verfahren ebenfalls umfasst:

- das automatische Lernen (102, 212) einer Funktion $G_{SVM}$, die die Kapazität $C_{n,k3}$ entsprechend der Kapazität $C_{n,k3-1}$ zurücksendet, und mindestens einer physikalischen Eigenschaft $cc_{1,k3}$, in Korrelation mit der zeitlichen Entwicklung der Kapazität der Zelle und gemessen zum Zeitpunkt k3, wobei dieses automatische Lernen die Ausführung (108) eines Lernalgorithmus, überwacht auf Grundlage einer Lerndatenbank, wobei diese Lerndatenbank Werte der Kapazität und für jeden Wert der physikalischen Eigenschaft, gemessen zum selben Zeitpunkt, und den vorherigen Wert der Kapazität, umfasst, und
- sobald die Funktion $G_{SVM}$ erlernt wurde, nutzt die Berechnung (190) der Vorhersage der Kapazität $C_{n,k3+1}$ bei der Ausführung der Etappe b) zu einem späteren Zeitpunkt k3+1 das Statusmodell, das vom nachfolgenden Verhältnis definiert wird $C_{n,k3+1} = G_{SVM}(C_{n,k3}, cc_{1,k3+1})$.

**2.** Verfahren nach Anspruch 1, bei dem die Funktion $G_{SVM}(C_{n,k3-1}, CC_{1,k3})$ durch das nachfolgende Verhältnis definiert wird: $G_{SVM}(C_{n,k3-1}, CC_{1,k3}) = C_{n,k3-1} + f_{svm}(cc_{1,k3})$, wobei $f_{svm}(CC_{1,k3})$ eine Funktion ist, die bei der Lernetappe auf Grundlage der Daten, die in der Lerndatenbank erfasst wurden, gelernt wurde.

**3.** Verfahren nach Anspruch 1 oder 2, bei dem:

- das Verfahren zu jedem Zeitpunkt k3 die Erfassung in der Lerndatenbank umfasst, und zwar:

• der Kapazität $C_{n,k3}$, vorhergesagt und anschließend berichtigt durch den Kalman-Filter bei der Etappe b), und

• der physikalischen Eigenschaft $cc_{1,k3}$, gemessen zum Zeitpunkt k3, ferner

- das automatische Lernen (212) der Funktion $G_{SVM}$ die Ausführung des Lernalgorithmus umfasst, der anhand dieser Lerndatenbank überwacht wird, in der die Kapazitäten $C_{n,k3}$, die vorhergesagt und anschließend durch den Kalman-Filter korrigiert wurden, erfasst wurden.

4. Verfahren nach Anspruch 3, bei dem:

- die Etappe b) ebenfalls die Schätzung (194) der Kovarianz $Pc_{k3}$ des Schätzungsfehlers der Kapazität $C_{n,k3}$ umfasst, und
- das automatische Lernen der Funktion $G_{SVM}$ automatisch ausgelöst wird (210) in Antwort auf das Überschreiten einer Schwelle, die von der geschätzten Kovarianz $Pc_{k3}$ vorbestimmt ist.

5. Verfahren nach einem beliebigen der vorgenannten Ansprüche, bei dem die Berechnung (196) der Vorhersage $\hat{z}_{k3}$ mithilfe des nachfolgenden Beobachtungsmodells ausgeführt wird:

$$\hat{z}_{k3} = \frac{\left( SOC_k - SOC_{k-N} \right)}{NT_e} . 3600 . C_{n,k3}$$

wobei:

- k der Zeitpunkt ist, der dem Zeitpunkt k3 am nächsten liegt,
- $SOC_k$ und $SOC_{k-N}$ die Ladestatus der Zelle zu den Zeitpunkten k und k-N sind,
- $C_{n,k3}$ im Beobachtungsmodell die Vorhersage der Kapazität der Zelle zum Zeitpunkt k3 ist, berechnet unmittelbar bevor sie berichtigt wird, und
- $T_e$ das Zeitintervall ist, das die beiden Zeitpunkte k und beliebiges k-1 trennt.

6. Verfahren nach einem beliebigen der vorangehenden Ansprüche, bei dem der überwachte Lernalgorithmus eine Support Vector Machine ist.

7. Verfahren nach einem beliebigen der vorangehenden Ansprüche, bei dem das Verfahren ebenfalls die Berechnung (200) des Gesundheitsstatus $SOH_{k3}$ der Zelle mithilfe des nachfolgenden Verhältnisses umfasst:

$$SOH_{k3} = C_{n,k3} / C_n^{ini} \text{ , wobei:}$$

- $C_{n,k3}$ die Kapazität der Zelle ist, geschätzt zum letzten Zeitpunkt k3, und
- $C_n^{ini}$ die anfängliche Kapazität der Zelle ist.

8. Automatisches Verfahren zur Schätzung des Ladestatus einer Zelle einer Batterie, umfassend:

a) den Erhalt (112) zu einem Zeitpunkt k eines gemessenen Werts $y_k$ der Spannung zwischen den Klemmen der Zelle und einer gemessenen Intensität $i_k$ des Lade- oder Entladestroms der Zelle,

b) die Schätzung (160) des Ladestatus $SOC_k$ der Zelle zum Zeitpunkt k auf Grundlage des gemessenen Werts $y_k$, der gemessenen Intensität $i_k$ und einer Kapazität $C_{n,k3}$ der Zelle, wobei diese Kapazität $C_{n,k3}$, ausgedrückt in Ah, die maximale Menge an elektrischer Energie darstellt, die in der Zelle zum Zeitpunkt k3 speicherbar ist, wobei der Zeitpunkt k3 der Zeitpunkt ist, zu dem die Kapazität $C_{n,k3}$ als dem Zeitpunkt k am nächsten geschätzt wurde, und

c) die Schätzung (188) der Kapazität $C_{n,k3}$ zu einem Zeitpunkt k3, wobei die Zeitpunkte k3 weniger häufig als die Zeitpunkte k sind,

**dadurch gekennzeichnet, dass** die Schätzung (188) der Kapazität $C_{n,k3}$ zu einem Zeitpunkt k3 entsprechend einem Verfahren durchgeführt wird, das mit einem beliebigen der vorangehenden Ansprüche konform ist.

9. Verfahren nach Anspruch 8, bei dem das Verfahren ebenfalls umfasst:

- die Aktualisierung (140) der Koeffizienten eines Filters $h_{t,k2+1}$ mit unendlicher Impulsantwort, wobei diese Aktualisierung umfasst:

• die Berechnung (148) einer Vorhersage $Vp_{D,k}$ einer Spannung $V_{D,k}$ an den Klemmen einer Impedanz der Zelle mithilfe des nachfolgenden Verhältnisses:

$$Vp_{D,k} = h_{t,k2} * X_k = \sum_{i=0}^{i=Nh} b_{i,k2} * i_{k-i} - \sum_{i=1}^{i=Mh} a_{i,k2} * V_{D,k-i}$$

wobei

- $i_{k-i}$ die Intensität, gemessen zum Zeitpunkt k-i, ist,
- $V_{D,k-i}$ die Spannung, gemessen an den Klemmen der Impedanz der Zelle zum Zeitpunkt k-i, ist,
- $a_{i,k2}$ und $b_{i,k2}$ die Koeffizienten des Filters $h_{t,k2}$ sind, aktualisiert zum Zeitpunkt k2, der dem Zeitpunkt k am nächsten liegt, und
- Nh und Mh ganze Konstanten sind, die streng über zwei liegen,

• die Berechnung (150) einer Abweichung $e_{RLS,k}$ zwischen dem gemessenen Wert $V_{D,k}$ und seiner Vorhersage $Vp_{D,k}$, wobei der gemessene Wert $V_{D,k}$ aus der Differenz $y_k - OCV(SOC_k)$ berechnet wird, wobei $OCV(SOC_k)$ eine vorbestimmte Funktion ist, die die Leerspannung zwischen den Klemmen der Zelle für den Ladestatus $SOC_k$ der Zelle zum Zeitpunkt k umkehrt,
• die Berichtigungen der Koeffizienten $a_{i,k2}$ und $b_{i,k2}$, um die Abweichung $e_{RLS,k}$ zu verkleinern, und

- sobald die Koeffizienten des Filters $h_{t,k2}$ aktualisiert wurden, die Schätzung (160) bei der Etappe b) des Ladestatus $SOC_k$ der Zelle mithilfe eines Kalman-Filters, indem das nachfolgende Beobachtungsmodell verwendet wird: $y_k = OCV(SOC_k) - h_{t,k2} * X_k$, wobei:

• $h_{t,k2}$ der Filter mit abgeschlossener Impulsantwort ist, dessen Koeffizienten zum Zeitpunkt k2, der dem Zeitpunkt k am nächsten ist, aktualisiert wurden, und
• $X_k$ der nachfolgende Vektor ist $[i_k, \dots, i_{k-Nh}, V_{D,k-1}, \dots, V_{D,k-Mh}]^T$.

10. Verfahren nach Anspruch 9, bei dem der Kalman-Filter, der bei der Etappe b) der Schätzung (160) des Ladestatus $SOC_k$ verwendet wird, ein Kalman-Filter mit Sigma-Punkten ist.

11. Träger (42) für die Erfassung von Informationen, umfassend Anweisungen für die Ausführung eines Schätzungsverfahrens entsprechend einem beliebigen der vorangehenden Ansprüche, wenn diese Anweisungen von einem elektronischen Rechner ausgeführt werden.

12. System für die Steuerung einer Batterie, die mit mindestens einer Zelle ausgerüstet ist, wobei dieses System einen elektronischen Rechner (44) umfasst, programmiert, um:

a) zu einem Zeitpunkt k eine gemessene Intensität $i_k$ des Lade- oder Entladestroms der Zelle zu erhalten,
b) die Kapazität $C_{n,k3}$ der Zelle zu einem Zeitpunkt k3 zu schätzen, indem ein Kalman-Filter verwendet wird, wobei diese Schätzung umfasst:

• die Berechnung einer Vorhersage der Kapazität $C_{n,k3}$ mithilfe eines Statusmodells, das die Kapazität $C_{n,k3}$ mit der Kapazität $C_{n,k3-1}$ derselben Zelle zu einem vorangehenden Zeitpunkt k3-1 verknüpft, ferner
• den Erhalt zum Zeitpunkt k3 einer messbaren physikalischen Größe $z_{k3}$, definiert durch das nachfolgende Verhältnis:

$$z_{k3} = \sum_{m=k-N}^{m=k-1} i_m$$

wobei k der Zeitpunkt ist, der dem Zeitpunkt k3 am nächsten ist, und N eine ganze Zahl von größer gleich eins ist, wobei $z_{k3}$ gleich $i_{k-1}$ ist, wenn N gleich eins ist,

• die Berechnung einer Vorhersage $\hat{z}_{k3}$ der messbaren physikalischen Größe $z_{k3}$ mithilfe eines Beobachtungsmodells, und

• die Berichtigung der Vorhersage der Kapazität $C_{n,k3}$ entsprechend der Abweichung zwischen der erhaltenen physikalischen Größe $z_{k3}$ und der Vorhersage $\hat{z}_{k3}$, berechnet auf Grundlage des Beobachtungsmodells, der Rechner (44) ist ebenfalls programmiert, um:

- automatisch eine Funktion $G_{SVM}$ zu lernen, die die Kapazität $C_{n,k3}$ entsprechend der Kapazität $C_{n,k3-1}$ zurücksendet, und mindestens einer physikalischen Eigenschaft $cc_{1,k3}$ in Korrelation mit der zeitlichen Entwicklung der Kapazität der Zelle und gemessen zum Zeitpunkt k3, wobei dieses automatische Lernen die Ausführung eines Lernalgorithmus umfasst, überwacht auf Grundlage einer Lerndatenbank, wobei diese Lerndatenbank Werte der Kapazität und für jeden Wert der physikalischen Eigenschaft, gemessen zum selben Zeitpunkt, und den vorherigen Wert der Kapazität, umfasst, und
- sobald die Funktion $G_{SVM}$ gelernt wurde, bei der Ausführung der Etappe b) zu einem späteren Zeitpunkt k3+1, die Vorhersage der Kapazität $C_{n,k3+1}$ zu berechnen, indem das Statusmodell verwendet wird, das vom nachfolgenden Verhältnis $C_{n,k3+1} = G_{SVM} (C_{n,k3}, cc_{1,k3+1})$ definiert ist.

**13.** Kraftfahrzeug (2), umfassend:

- mindestens ein Antriebsrad (6),
- einen Elektromotor (4), der geeignet ist, dieses Antriebsrad in Rotation zu versetzen, um das Kraftfahrzeug fortzubewegen,
- eine Batterie (10), umfassend mindestens eine Zelle (18-21), die imstande ist, elektrische Energie zu speichern und im Wechsel elektrische Energie zurückzugeben, um den Elektromotor zu speisen, wobei diese Zelle mindestens zwei Klemmen (30, 32) umfasst, über die sie elektrisch an den Elektromotor angeschlossen ist,
- einen Voltmesser (34), elektrisch angeschlossen zwischen den Klemmen der Zelle, um die Spannung zwischen diesen Klemmen zu messen,
- einen Amperemesser (36), in Serie angeschlossen mit der elektrischen Zelle, um die Intensität des Lade- oder Entladestroms dieser Zelle zu messen, und
- ein System (40) für die Steuerung der Batterie, angeschlossen am Voltmesser und Amperemesser, wobei dieses Steuersystem einen programmierbaren elektronischen Rechner (44) umfasst, der geeignet ist, um den Ladestatus der Zelle der Batterie auf Grundlage der Messungen des Voltmessers und des Amperemessers zu schätzen,

**dadurch gekennzeichnet, dass** das System (40) für die Steuerung der Batterie mit dem Anspruch 12 konform ist.

## Claims

**1.** Automatic method of estimation of the capacitance of a cell of a battery, this method involving:

a) the acquisition (112), at a time k, of a measured charging or discharging current intensity ik of the cell,
b) the estimation (188) of the capacitance $C_{n,k3}$ of the cell at a time k3 by using a Kalman filter, this estimation involving:

• the calculating (190) of a prediction of the capacitance $C_{n,k3}$ with the help of a model of state which relates the capacitance $C_{n,k3}$ to the capacitance $C_{n,k3-1}$ of this same cell at a previous time k3-1, then
• the acquisition (196), at time k3, of a measurable physical quantity $z_{k3}$ defined by the following relation:

$$z_{k3} = \sum_{m=k-N}^{m=k-1} i_m$$

where k is the closest time to the time k3 and N is an integer greater than or equal to one, $z_{k3}$ being equal to $i_{k-1}$ when N is equal to one,
• the calculating (196) of a prediction $\hat{z}_{k3}$ of the measurable physical quantity $z_{k3}$ with the help of a model of observation, and
• the correction (198) of the prediction of the capacitance $C_{n,k3}$ as a function of the difference between the acquired physical quantity $z_{k3}$ and the prediction $\hat{z}_{k3}$ calculated from the model of observation,

the method also involves:

- the automatic learning (102, 212) of a function $G_{SVM}$ that returns the capacitance $C_{n,k3}$ as a function of the capacitance $C_{n,k3-1}$ and at least one physical characteristic $cc_{1,k3}$ correlated with the change over time of the capacitance of the cell and measured at time k3, this automatic learning involving the execution (108) of a supervised learning algorithm on a learning database, this learning database containing values of the capacitance and, for each value of the capacitance, the value of the physical characteristic measured at the same time and the preceding value of the capacitance, and
- once the function $G_{SVM}$ has been learned, during the execution of step b) at a later time k3+1, the calculating (190) of the prediction of the capacitance $C_{n,k3+1}$ utilizes the model of state defined by the following relation $C_{n,k3+1} = G_{SVM}(C_{n,k3}, cc_{1,k3+1})$.

2. Method according to Claim 1, wherein the function $G_{SVM}(C_{n,k3-1}, cc_{1,k3})$ is defined by the following relation: $G_{SVM}(C_{n,k3-1}, cc_{1,k3}) = C_{n,k3-1} + f_{svm}(cc_{1,k3})$, where $f_{svm}(cc_{1,k3})$ is a function learned during the learning step from data recorded in the learning database.

3. Method according to Claim 1 or 2, wherein:

- at each time k3, the method involves the recording in the learning database:

  • of the capacitance $C_{n,k3}$ predicted and then corrected by the Kalman filter during step b), and
  • of the physical characteristic $cc_{1,k3}$ measured at time k3, then

- the automatic learning (212) of the function $G_{SVM}$ involves the execution of the supervised learning algorithm on this learning database in which the capacitances $C_{n,k3}$ predicted and then corrected by the Kalman filter have been recorded.

4. Method according to Claim 3, wherein:

- step b) likewise involves the estimation (194) of the covariance $Pc_{k3}$ of the error of estimation of the capacitance $C_{n,k3}$, and
- the automatic learning of the function $G_{SVM}$ is triggered automatically (210) in response to the crossing of a predetermined threshold by the estimated covariance $Pc_{k3}$.

5. Method according to any one of the preceding claims, wherein the calculating (196) of the prediction $\hat{z}_{k3}$ is done with the help of the following model of observation:

$$\hat{z}_{k3} = \frac{(SOC_k - SOC_{k-N})}{NT_e} . 3600 . C_{n,k3}$$

where:

- k is the closest time to the time k3,

- $SOC_k$ and $SOC_{k-N}$ are the states of charge of the cell at times k and k-N,
- $C_{n,k3}$ is, in this model of observation, the prediction of the capacitance of the cell at time k3 calculated just before being corrected, and
- $T_e$ is the time interval separating any two times k and k-1.

6. Method according to any one of the preceding claims, wherein the supervised learning algorithm is a support vector machine.

7. Method according to any one of the preceding claims, wherein the method also involves the calculating (200) of the state of health $SOH_{k3}$ of the cell with the help of the following relation: $SOH_{k3} = C_{n,k3}/C_n^{ini}$, where:

   - $C_{n,k3}$ is the capacitance of the cell estimated at the most recent time k3, and
   - $C_n^{ini}$ is the initial capacitance of the cell.

8. Automatic method of estimation of the state of charge of a cell of a battery, this method involving:

   a) the acquisition (112), at a time k, of a measured value $y_k$ of the voltage between terminals of the cell, and a measured charging or discharging current intensity $i_k$ of the cell,
   b) the estimation (160) of the state of charge $SOC_k$ of the cell, at time k, from the measured value $y_k$, the measured intensity $i_k$ and a capacitance $C_{n,k3}$ of the cell, this capacitance $C_{n,k3}$, expressed in Ah, representing the maximum quantity of electrical energy storable in the cell at time k3, the time k3 being the time at which the capacitance $C_{n,k3}$ was estimated the closest to time k, and
   c) the estimation (188) of the capacitance $C_{n,k3}$ at a time k3, the times k3 being less frequent than the times k,

   **characterized in that** the estimation (188) of the capacitance $C_{n,k3}$ at a time k3 is done by a method in accordance with one of the preceding claims.

9. Method according to Claim 8, wherein the method also involves:

   - the updating (140) of the coefficients of an infinite impulse response filter $h_{t,k2+1}$, this updating involving:

      • the calculating (148) of a prediction $Vp_{D,k}$ of a voltage $V_{D,k}$ at the terminals of an impedance of the cell with the help of the following relation:

$$Vp_{D,k} = h_{t,k2} * X_k = \sum_{i=0}^{i=Nh} b_{i,k2} * i_{k-i} - \sum_{i=1}^{i=Mh} a_{i,k2} * V_{D,k-i}$$

      where

         - $i_{k-1}$ is the intensity measured at time k-i,
         - $V_{D,k-1}$ is the voltage measured at the terminals of the impedance of the cell at time k-i,
         - $a_{i,k2}$ and $b_{i,k2}$ are the coefficients of the filter $h_{t,k2}$ updated at the closest time k2 to the time k, and
         - Nh and Mh are constant integers absolutely greater than two,

      • the calculating (150) of a difference $e_{RLS,k}$ between the measured value $V_{D,k}$ and its prediction $Vp_{D,k}$, where the measured value $V_{D,k}$ is obtained from the difference $y_k - OCV(SOC_k)$, where $OCV(SOC_k)$ is a predetermined function which returns the no-load voltage between the terminals of the cell for the state of charge $SOC_k$ of the cell at time k,
      • the correction of the coefficients $a_{i,k2}$ and $b_{i,k2}$ to minimize the difference $e_{RLS,k}$, and

   - once the coefficients of the filter $h_{t,k2}$ have been updated, the estimation (160), during step b), of the state of charge $SOC_k$ of the cell with the help of a Kalman filter using the following model of observation: $y_k = OCV(SOC_k) - h_{t,k2} * X_k$, where:

      • $h_{t,k2}$ is the finite impulse response filter whose coefficients were updated at the time k2 closest to the time k, and

• $X_k$ is the following vector $[i_k, \ldots , i_{k-Nh}, V_{D,k-1}, \ldots , V_{D,k-Mh}]^T$.

10. Method according to Claim 9, wherein the Kalman filter used during step b) for estimation (160) of the state of charge $SOC_k$ is a sigma point Kalman filter.

11. Data recording medium (42), comprising instructions for the execution of a method of estimation in accordance with any one of the preceding claims, when these instructions are executed by an electronic computer.

12. Battery management system outfitted with at least one cell, this system comprising an electronic computer (44) programmed to:

> a) acquire, at a time k, a measured charging or discharging current intensity $i_k$ of the cell,
> b) estimate the capacitance $C_{n,k3}$ of the cell at a time k3 by using a Kalman filter, this estimation involving:
>
>> • the calculating of a prediction of the capacitance $C_{n,k3}$ with the help of a model of state which relates the capacitance $C_{n,k3}$ to the capacitance $C_{n,k3-1}$ of this same cell at a previous time k3-1, then
>> • the acquisition, at time k3, of a measurable physical quantity zk3 defined by the following relation:

$$z_{k3} = \sum_{m=k-N}^{m=k-1} i_m$$

>> where k is the closest time to the time k3 and N is an integer greater than or equal to one, $z_{k3}$ being equal to $i_{k-1}$ when N is equal to one,
>> • the calculating of a prediction $\hat{z}_{k3}$ of the measurable physical quantity $z_{k3}$ with the help of a model of observation, and
>> • the correction of the prediction of the capacitance $C_{n,k3}$ as a function of the difference between the acquired physical quantity $z_{k3}$ and the prediction $\hat{z}_{k3}$ calculated from the model of observation,
>
> the computer (44) is also programmed to:
>
>> - automatically learn a function $G_{SVM}$ that returns the capacitance $C_{n,k3}$ as a function of the capacitance $C_{n,k3-1}$ and at least one physical characteristic $cc_{1,k3}$ correlated with the change over time of the capacitance of the cell and measured at time k3, this automatic learning involving the execution of a supervised learning algorithm on a learning database, this learning database containing values of the capacitance and, for each value of the capacitance, the value of the physical characteristic measured at the same time and the preceding value of the capacitance, and
>> - once the function $G_{SVM}$ has been learned, during the execution of step b) at a later time k3+1, calculate the prediction of the capacitance $C_{n,k3+1}$ by using the model of state defined by the following relation $C_{n,k3+1} = G_{SVM}(C_{n,k3}, cc_{1,k3+1})$.

13. Automobile (2) comprising:

> - at least one powered wheel (6),
> - an electric motor (4) able to drive this powered wheel in rotation in order to move the automobile,
> - a battery (10) comprising at least one cell (18-21) able to store electrical energy and, alternately, return the electrical energy in order to energize the electric motor, this cell comprising two terminals (30, 32) by means of which it is electrically connected to the electric motor,
> - a voltmeter (34) connected electrically between the terminals of the cell to measure the voltage between these terminals,
> - an ammeter (36) connected in series with the electric cell to measure the charging or discharging current intensity of this cell, and
> - a battery management system (40) connected to the voltmeter and to the ammeter, this management system comprising a programmable electronic computer (44) able to estimate the state of charge of the cell of the battery from measurements of the voltmeter and the ammeter,
>
> **characterized in that** the battery management system (40) is in accordance with Claim 12.

Fig. 1

Fig. 2

Fig. 3

$$SOC_{k+1} = SOC_k + \frac{i_k * T_e}{C_{n,k3}} + w_k$$

62

## Fig. 4

$$y_k = OCV(SOC_k) - h_{t,k2} * X_k + v_k$$

64

## Fig. 5

$$C_{n,k3+1} = G_{svm}(C_{n,k3}; E_C) + w_{3,k3}$$

74

## Fig. 6

$$\hat{z}_{k3} = \frac{(SOC_k - SOC_{k-N})}{N\,T_e} \cdot 3600 \cdot C_{n,k3} + v_{3,k3}$$

76

## Fig. 7

Fig. 8

$$\begin{bmatrix} SOC_{k+1} \\ V_{Diff,\,k+1} \end{bmatrix} = \begin{bmatrix} 1 & 0 \\ 0 & 1 - \dfrac{T_e}{R_D * C_D} \end{bmatrix} * \begin{bmatrix} SOC_k \\ V_{Diff,\,k} \end{bmatrix} + \begin{bmatrix} -\dfrac{T_e}{C_n^{ini}} \\ \dfrac{T_e}{C_D} \end{bmatrix} * i_k + w_k$$

Fig. 9

$$y_k = OCV(SOC_k) - V_{Diff,\,k} - RO^{ini} * i_k + v_k$$

Fig. 10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2006111854 A1
- US 2014058595 A1

- WO 2006057468 A

**Littérature non-brevet citée dans la description**

- **L. PLETT et al.** Extended Kalman filtering for battery management systems of LiPB-based HEV battery packs. *journal of Power Sources,* 2004, 252-292
- **JULIER J. SIMON et al.** A New Extension of the Kalman Filter to Nonlinear Systems. *Proc. SPIE 3068, Signal Processing, Sensor Fusion, and Target Récognition,* 28 Juillet 1997, vol. VI, 182
- **GREGORY L. PLETT.** Sigma-point Kalman filtering for battery management systems of LiPB-based HEV battery packs. *Journal of Power Sources,* 2006, vol. 161, 1356-1368
- Practical selection of svm parameters and noise estimation for svm régression. **V. CHERKASSKY.** Yunqian Ma Vladimir Cherkassky. ELSEVIER, 2003

- **MEHRA, R.K.** On the identification of variances and adaptative Kalman Filtering. *Automatic Control, IEEE Transaction on,* Avril 1970, vol. 15 (2), 175-184
- **Y. BAR-SHALOM et al.** Estimation with Applications to Tracking and Navigation, Theory Algorithms and Software. Wiley Inter-science, 2001
- **GREGORY L. PLETT.** Recursive approximate weighted total least squares estimation of battery cell total capacity. *Journal of Power Sources,* 2011, vol. 196, 2319-2331
- **GREGORY L. PLETT.** Recursive Approximate Weighted Total Least Squares Estimation of Battery Cell Total Capacity. *Journal of Power Source,* 2011, vol. 196, 2319-2331